# EUROPEAN PATENT APPLICATION

(11) **EP 4 852 697 A1**
(43) Date of publication of application: **09.12.2026**
(21) Application number: 25220002.7
(22) Date of filing: 02.12.2025
(51) Int. Cl.: H10W 20/00, H10D 30/00, H10D 30/67, H10D 62/10, H10D 84/03, H10D 84/85, H10W 20/41, H10W 20/40, H10W 20/43

(54) **INTEGRATED CIRCUIT STRUCTURE WITH DOUBLE-HEIGHT CELL FOR ENHANCED PERFORMANCE**

(30) Priority: 06.06.2025 US 202519230569
(71) Applicant: INTEL Corporation, Santa Clara, CA 95054 (US)
(72) Inventor: POKHREL, Khem, El Dorado Hills, 95762 (US); GUHA NEOGI, Tuhin, Sherwood, 97007 (US); BOUCHE, Guillaume, Portland, 97217 (US)
(74) Representative: Viering, Jentschura & Partner mbB Patent- und Rechtsanwälte

(57) **Abstract**

Integrated circuit structures with double-height or triple-height cells for enhanced performance may include a connection between NMOS and PMOS drain regions that passes under the metallization stack (e.g., rather than being routed through a metal layer of the metallization stack). In some examples that include nanoribbon-based transistors, a cell (e.g., double-height cell) may include a wide nanoribbon that may occupy the space of two narrower nanoribbons. In one such example where a voltage rail may be over and aligned with the wide nanoribbon and where a conductive via bar is present between the voltage rail and the wide nanoribbon, the conductive via bar may be a partial via bar that is absent from the area over the drain region.

## Description

### Background

For the past several decades, the scaling of features in integrated circuit (IC) structures has been a driving force behind an ever-growing semiconductor industry. Scaling to smaller and smaller features enables increased densities of functional units on the limited real estate of semiconductor chips. For example, shrinking transistor size allows for the incorporation of an increased number of memory or logic devices on a chip, lending to the fabrication of products with increased capacity. The drive for the ever-increasing capacity, however, is not without issue. The necessity to optimize every portion of an IC structure becomes increasingly significant.

### Brief Description of the Drawings

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIG. 1 provides a perspective view of an example nanoribbon-based field-effect transistor (FET), according to some embodiments of the present disclosure.
FIG. 2 is a top-down plan view of an example of an IC structure including a double-height cell, according to some embodiments of the present disclosure.
FIG. 3A is a top-down plan view of an example of an IC structure including a transistor arrangement in a double-height cell and a partial via contact rail under a power rail, according to some embodiments of the present disclosure.
FIG. 3B illustrates another top-down plan view of a portion of the IC structure shown in FIG. 3A, according to some embodiments of the present disclosure.
FIG. 4 is a top-down plan view of another example of an IC structure including a transistor arrangement in a double-height cell and a partial via contact rail under a power rail, according to some embodiments of the present disclosure.
FIG. 5A is a top-down plan view of an example of an IC structure including a transistor arrangement in a triple-height cell and a partial via contact rail under a power rail, according to some embodiments of the present disclosure.
FIGS. 5B and 5C illustrate different cross-sectional views of the IC structure of FIG. 5A according to some embodiments of the present disclosure.
FIG. 6 illustrates a cross-sectional side view of an example of an IC structure with backside power rails, according to some embodiments of the present disclosure.
FIG. 7 is a top view of a wafer and dies that may include any of the IC structures disclosed herein, in accordance with any of the embodiments disclosed herein.
FIG. 8 is a side, cross-sectional view of an IC device that may include any of the IC structures disclosed herein, in accordance with any of the embodiments disclosed herein.
FIG. 9 is a side, cross-sectional view of an IC package that may include any of the IC structures disclosed herein, in accordance with various embodiments.
FIG. 10 is a side, cross-sectional view of an IC device assembly that may include any of the IC structures disclosed herein, in accordance with any of the embodiments disclosed herein.
FIG. 11 is a block diagram of an example electrical device that may include any of the IC structures disclosed herein, in accordance with any of the embodiments disclosed herein.

### Detailed Description

Disclosed herein are integrated circuit (IC) structures and techniques for forming double-height cells for enhanced performance. Although examples herein refer to double-height cells, the structures described may apply to other sized cells (e.g., triple-height cells, etc.). The systems, methods and devices of this disclosure each have several innovative aspects, no single one of which is solely responsible for all desirable attributes disclosed herein. Details of one or more implementations of the subject matter described in this specification are set forth in the description below and the accompanying drawings.

Integrated circuits may be designed using a library of cells. For example, a cell in such a library may define a pre-designed component or logic gate, such as an inverter, a flip-flop, or other component. Cells in a library may be designed to fit within defined physical and electrical standards so that the cells may be laid out in the desired locations to build the desired circuit. For example, cells may be "standard height" or "single height" cells with a pre-defined cell size (e.g., height and width), where the height may refer to a dimension of the cell along the y-axis in a top-down view, and the width may refer to a dimension of the cell along an x-axis in a top-down view. Other cells may be "double height," where a double-height cell has a larger height than the standard cell (e.g., twice the height).

Cells may include transistors that can classify as N-type (e.g., N-type FET (NFET) or N-type metal-oxide-semiconductor (NMOS) transistors) and/or P-type (e.g., P-type FET (PFET) or P-type metal-oxide-semiconductor (PMOS) transistors) based on the type of charge carriers that conduct current in the transistor channel. An N-type transistor (e.g., NFET or NMOS) operates using electrons as the primary charge carriers within an N-type semiconductor channel. Both the source and drain regions are N-doped (i.e., doped with N-type dopants), meaning they contain an excess of electrons. N-type dopants are dopants deliberately added to a semiconductor material (e.g., to S/D regions of an N-type transistor) to introduce additional electrons into the crystal lattice, and that these dopants are also known as "donor" impurities. An N-type transistor turns ON when a positive voltage is applied to the gate, creating an electric field that attracts electrons into the channel, allowing current to flow. Conversely, when the gate voltage is low or zero, the channel remains nonconductive, keeping the transistor in the OFF state. A P-type transistor (e.g., PFET or PMOS) operates using holes as the primary charge carriers within a P-type semiconductor channel. The source and drain regions are P-doped (i.e., doped with P-type dopants), meaning they contain an excess of holes. P-type dopants are dopants deliberately added to a semiconductor material (e.g., to S/D regions of a P-type transistor) to introduce additional holes into the crystal lattice, and that these dopants are also known as "acceptor" impurities. A P-type transistor turns ON when a negative voltage is applied to the gate, creating an electric field that attracts holes into the channel, allowing current to flow. Conversely, when the gate voltage is high or zero, the channel remains nonconductive, keeping the transistor in the OFF state. Complementary Metal-Oxide-Semiconductor (CMOS) technology uses both N-type and P-type transistors to build efficient logic circuits. For example, a basic CMOS inverter requires one N-type and one P-type transistors with connected gates.

As cell dimensions are scaled down, the dimensions of the transistors in those cells are also shrinking. For example, for nanoribbon-based transistors, as cell height shrinks, the width of a nanoribbon of a nanoribbon-based transistor in the cell may also shrink. In some cases, smaller nanoribbon widths can negatively impact device performance, such as in high-current driver circuits. In some examples, double-height and triple-height cells may be selectively utilized in critical paths to boost frequency and performance without significantly increasing the cell footprint. For example, in nanosheet/nanoribbon-based technologies, double-height and triple-height cells may be effective in enhancing the frequency capabilities of area-constrained low-power blocks.

In double-height cells, connecting transistor terminals (such as the drain regions of NMOS and PMOS transistors) can present a challenge, e.g., due to the risk of electrical shorts with a conductive via contact rail located beneath a power rail. A conductive via contact rail, which is a conductive structure that may enable improved power delivery by reducing resistance, typically runs parallel to the power rails and may be positioned in close proximity to the transistor drain regions. When connecting NMOS and PMOS drain regions within a double-height cell, the drain connections are typically routed through metal layers that are higher than M0, such as M1, due to the presence of a conductive via contact rail and the risk of a short between a drain region and voltage rail. Routing the drain connections through a higher metal layer may mitigate the shorting problem but introduce additional capacitance to the circuit and consume valuable routing resources, further complicating the design of high-performance, area-efficient cells.

In accordance with examples described herein, IC structures with double-height cells for enhanced performance may include a connection between NMOS and PMOS drain regions that passes under the metallization stack (e.g., rather than being routed through a metal layer of the metallization stack) for double or triple-height cells. In some examples that include nanoribbon-based transistors, a cell (e.g., double-height cell) may include a wide nanoribbon that may occupy the space of two narrower nanoribbons. In one such example where a voltage rail is over and aligned with the wide nanoribbon and a conductive via contact rail is present between the voltage rail and the wide nanoribbon, the conductive via contact rail may be a partial via contact rail that is absent from the area over the drain region. In one such example, a conductive contact structure may pass under the voltage rail without shorting to the voltage rail due to the absence of the via contact rail over the drain region. In another example in which the power rail is not directly over and aligned with the wide nanoribbon, the via contact rail may be absent from below the power rail in a region where a drain contact structure couples two drain regions. Thus, the drain regions in a circuit may be coupled together without using interconnects in metal layers over the device region.

IC structures as described herein, in particular IC structures including a double-height cell for enhanced performance as described herein, may be implemented in one or more components associated with an IC or/and between various such components. In various embodiments, components associated with an IC include, for example, transistors, diodes, power sources, resistors, capacitors, inductors, sensors, transceivers, receivers, antennas, etc. Components associated with an IC may include those that are mounted on an IC or those connected to an IC. The IC may be either analog or digital and may be used in a number of applications, such as microprocessors, optoelectronics, logic blocks, audio amplifiers, etc., depending on the components associated with the IC. In some embodiments, IC structures as described herein may be included in a radio frequency IC (RFIC), which may, e.g., be included in any component associated with an IC of a radio frequency (RF) receiver, an RF transmitter, or an RF transceiver, e.g., as used in telecommunications within base stations (BS) or user equipment (UE). Such components may include, but are not limited to, power amplifiers, low-noise amplifiers, RF filters (including arrays of RF filters, or RF filter banks), switches, upconverters, downconverters, and duplexers. In some embodiments, IC structures as described herein may be included in memory devices or circuits. In some embodiments, IC structures as described herein may be employed as part of a chipset for executing one or more related functions in a computer.

For purposes of explanation, specific numbers, materials, and configurations are set forth in order to provide a thorough understanding of the illustrative implementations. However, it will be apparent to one skilled in the art that the present disclosure may be practiced without the specific details or/and that the present disclosure may be practiced with only some of the described aspects. In other instances, well-known features are omitted or simplified in order not to obscure the illustrative implementations. The terms "substantially," "close," "approximately," "near," and "about," generally refer to being within +/- 10% of a target value, e.g., within +/- 5% of a target value, based on the context of a particular value as described herein or as known in the art. Similarly, terms indicating orientation of various elements, e.g., "coplanar," "perpendicular," "orthogonal," "parallel," or any other angle between the elements, generally refer to being within +/- 10% of a target value, e.g., within +/- 5% of a target value, based on the context of a particular value as described herein or as known in the art.

In the following description, references are made to the accompanying drawings that form a part hereof, and in which is shown, by way of illustration, embodiments that may be practiced. It is to be understood that other embodiments may be utilized, and structural or logical changes may be made without departing from the scope of the present disclosure. Therefore, the following detailed description is not to be taken in a limiting sense.

In the drawings, while some schematic illustrations of example structures of various devices and assemblies described herein may be shown with precise right angles and straight lines, this is simply for ease of illustration, and embodiments of these assemblies may be curved, rounded, or otherwise irregularly shaped as dictated by, and sometimes inevitable due to, the fabricating processes used to fabricate semiconductor device assemblies. Therefore, it is to be understood that such schematic illustrations may not reflect real-life process limitations which may cause the features to not look so "ideal" when any of the structures described herein are examined using e.g., scanning electron microscopy (SEM) images or transmission electron microscope (TEM) images. In such images of real structures, possible processing defects could also be visible, e.g., not-perfectly straight edges of materials, tapered vias or other openings, inadvertent rounding of corners or variations in thicknesses of different material layers, occasional screw, edge, or combination dislocations within the crystalline region, and/or occasional dislocation defects of single atoms or clusters of atoms. There may be other defects not listed here but that are common within the field of device fabrication. Inspection of layout and mask data and reverse engineering of parts of a device to reconstruct the circuit using e.g., optical microscopy, TEM, or SEM, and/or inspection of a cross-section of a device to detect the shape and the location of various device elements described herein using, e.g., Physical Failure Analysis (PFA) would allow determination of the presence of IC structures including a double-height cell for enhanced performance as described herein.

Various aspects of the illustrative implementations will be described using terms commonly employed by those skilled in the art to convey the substance of their work to others skilled in the art. For example, the terms "oxide," "carbide," "nitride," "silicide," etc. refer to compounds containing, respectively, oxygen, carbon, nitrogen, silicon, etc.; the term "high-k dielectric" refers to a material having a higher dielectric constant than silicon oxide; the term "low-k dielectric" refers to a material having a lower dielectric constant than silicon oxide. Materials referred to herein with formulas or as compounds cover all materials that include elements of the formula or a compound, e.g., TiSi or titanium silicide may refer to any material that includes titanium and silicon, WN or tungsten nitride may refer to any material that includes tungsten and nitrogen, etc. The term "insulating" means "electrically insulating," the term "conducting" means "electrically conducting," unless otherwise specified. Furthermore, the term "connected" may be used to describe a direct electrical or magnetic connection between the things that are connected, without any intermediary devices, while the term "coupled" may be used to describe either a direct electrical or magnetic connection between the things that are connected, or an indirect connection through one or more passive or active intermediary devices (e.g., physically coupled, conductively coupled, e.g., directly electrically connected). A first component described to be electrically coupled to a second component means that the first component is in conductive contact with the second component (i.e., that a conductive pathway is provided to route electrical signals/power between the first and second components).

Various operations may be described as multiple discrete actions or operations in turn, in a manner that is most helpful in understanding the claimed subject matter. However, the order of description should not be construed as to imply that these operations are necessarily order dependent. These operations may not be performed in the order of presentation. Operations described may be performed in a different order from the described embodiment. Various additional operations may be performed, and/or described operations may be omitted in additional embodiments.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). The term "between," when used with reference to measurement ranges, is inclusive of the ends of the measurement ranges.

The description uses the phrases "in an embodiment" or "in embodiments," which may each refer to one or more of the same or different embodiments. The terms "comprising," "including," "having," and the like, as used with respect to embodiments of the present disclosure, are synonymous. The disclosure may use perspective-based descriptions such as "above," "below," "top," "bottom," and "side"; such descriptions are used to facilitate the discussion and are not intended to restrict the application of disclosed embodiments. The accompanying drawings are not necessarily drawn to scale. Unless otherwise specified, the use of the ordinal adjectives "first," "second," and "third," etc., to describe a common object, merely indicate that different instances of like objects are being referred to and are not intended to imply that the objects so described must be in a given sequence, either temporally, spatially, in ranking or in any other manner. Although some materials may be described in singular form, such materials may include a plurality of materials, e.g., a semiconductor material may include two or more different semiconductor materials.

For purposes of illustrating IC structures including a double-height cell for enhanced performance, described herein, it might be useful to first understand phenomena that may come into play during IC fabrication. The following foundational information may be viewed as a basis from which the present disclosure may be properly explained. Such information is offered for purposes of explanation only and, accordingly, should not be construed in any way to limit the broad scope of the present disclosure and its potential applications.

Non-planar transistors such as double-gate transistors, trigate transistors, FinFETs, nanowire, and nanoribbon transistors refer to transistors having a non-planar architecture. In comparison to a planar architecture where the transistor channel has only one confinement surface, a non-planar architecture is any type of architecture where the transistor channel has more than one confinement surface. A confinement surface refers to a particular orientation of the channel surface that is confined by the gate field. Non-planar transistors potentially improve performance relative to transistors having a planar architecture, such as single-gate transistors.

A gate enclosure of a transistor refers to a portion of the gate stack which sets the amount of a "top-down" space that a gate stack consumes beyond the channel confinement surface. Conventional non-planar transistor architectures all utilize gate enclosures that not only consume space but also add parasitic capacitance, impacting area scaling, speed improvements, and energy savings. A nanocomb transistor architecture (also sometimes referred to as a forksheet architecture) has been proposed in the literature as a scaling booster to reduce the cell dimensions and parasitic capacitance, where the name "nanocomb/forksheet" arises because of its complex bilateral finned structure. In an example nanocomb transistor arrangement, the nanoribbons are coupled with a dielectric "spine" or wall, and there is no gate enclosure on one of the two sides of the vertical stack of lateral nanoribbons or nanosheets (referred to in the following as "nanoribbons"), while the gate enclosure on the other side still remains. In other examples, a nanocomb transistor arrangement may include a portion of the gate electrode material and/or gate insulator between the dielectric spine and the nanoribbons.

As used herein, the term "nanoribbon" refers to an elongated semiconductor structure having a long axis parallel to a support structure (e.g., a substrate, a chip, or a wafer) over which a transistor arrangement is provided. In some settings, the term "nanoribbon" has been used to describe an elongated semiconductor structure that has a rectangular transverse cross-section (i.e., a cross-section in a plane perpendicular to the longitudinal axis of the structure), while the term "nanowire" has been used to describe a similar structure but with a circular or square-like transverse cross-section. In the present disclosure, the term "nanoribbon" is used to describe both such nanoribbons (including nanosheets) and nanowires, as well as elongated semiconductor structures with a longitudinal axis parallel to the support structures and with having transverse cross-sections of any geometry (e.g., oval, or a polygon with rounded corners). As used herein, the term "face of a nanoribbon" refers to any of the confinement surfaces (i.e., interfaces of the semiconductor material of the nanoribbon with the gate stack) of the nanoribbon which are substantially parallel to the support structure when a nanoribbon extends in a direction parallel to the support structure, while the term "sidewall of a nanoribbon" refers to any of the confinement surfaces of the nanoribbon connecting the bottom face and the top face (the bottom face being the face of the nanoribbon that is closer to the support structure than the top face).

While the descriptions are provided herein with reference to nanoribbons, the principles of IC structures including a merged nanoribbon-based transistor along a nanocomb transistor ribbon path, described herein, are equally applicable to arrangements where a channel material is shaped as a structure where the length of the structure (e.g., a dimension measured along the y-axis of the example coordinate system shown in the present drawings) is similar to the thickness of the structure (e.g., a dimension measured along the z-axis of the example coordinate system shown in the present drawings).

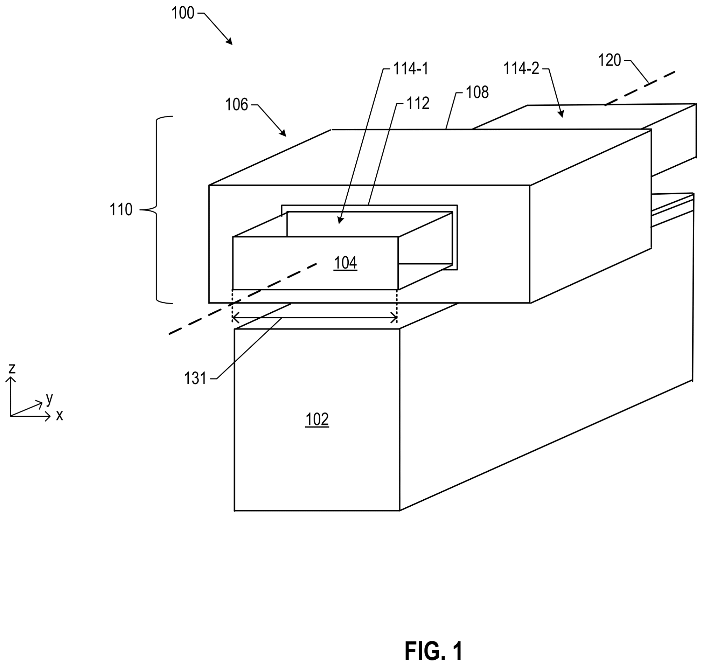

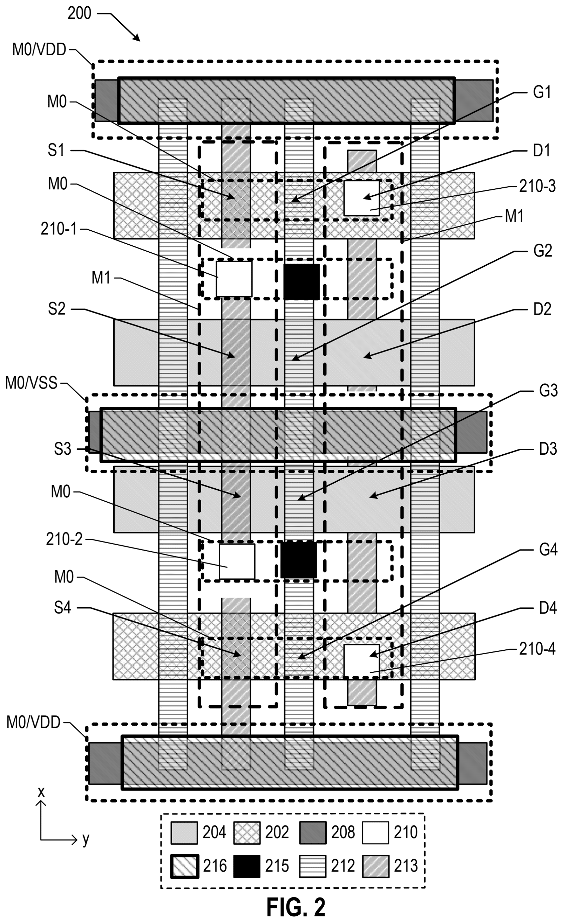

FIG. 1 provides a perspective view of an example IC structure 100 with a nanoribbon transistor 110, according to some embodiments of the present disclosure. For example, in various embodiments, the transistor 110 formed on the basis of a nanoribbon 104, shown in FIG. 1, may be formed on the basis of any of the nanoribbon-based transistor arrangements shown in any of FIGS. 2, 3A-3B, 4, 5A-5C, and 6. In some of those examples, the nanoribbon-based transistor arrangement is a nanocomb transistor that is formed in the stacks of lateral nanoribbons separated by a dielectric wall. As shown in FIG. 1, the IC structure 100 includes a semiconductor material formed as a nanoribbon 104 extending substantially parallel to a support 102. The transistor 110 may be formed on the basis of the nanoribbon 104 by having a gate stack 106 wrap around at least a portion of the nanoribbon referred to as a "channel portion" and by having source and drain regions, shown in FIG. 1 as a first S/D region 114-1 and a second S/D region 114-2 (referred to herein as simply "S/D regions" 114), on either side of the gate stack 106. One of the S/D regions 114 is a source region and the other one is a drain region. However, because, as is common in the field of FETs, designations of source and drain are often interchangeable, they are simply referred to herein as a first S/D region 114-1 and a second S/D region 114-2.

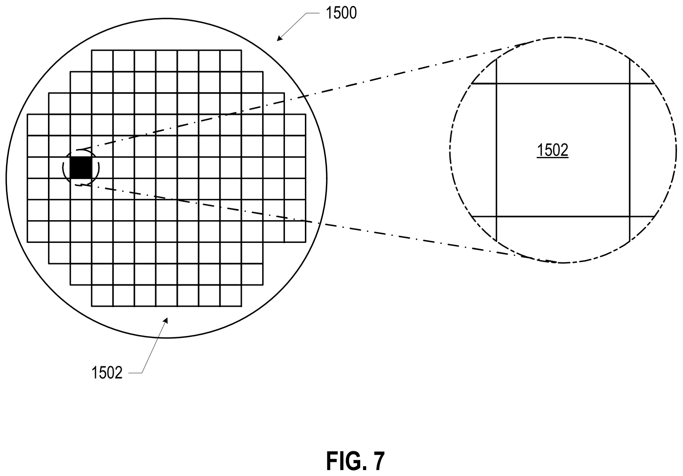

Implementations of the present disclosure may be formed or carried out on any suitable support 102, such as a substrate, a die, a wafer, or a chip. The support 102 may, e.g., be the wafer 1500 of FIG. 7, discussed below, and may be, or be included in, a die, e.g., the singulated die 1502 of FIG. 7, discussed below. The support 102 may be a semiconductor substrate composed of semiconductor material systems including, for example, N-type or P-type materials systems. In one implementation, the semiconductor substrate may be a crystalline substrate formed using a bulk silicon or a silicon-on-insulator (SOI) substructure. In other implementations, the semiconductor substrate may be formed using alternate materials, which may or may not be combined with silicon, that include, but are not limited to, germanium, silicon germanium, indium antimonide, lead telluride, indium arsenide, indium phosphide, gallium arsenide, aluminum gallium arsenide, aluminum arsenide, indium aluminum arsenide, aluminum indium antimonide, indium gallium arsenide, gallium nitride, indium gallium nitride, aluminum indium nitride or gallium antimonide, or other combinations of group III-V materials (i.e., materials from groups III and V of the periodic system of elements), group II-VI (i.e., materials from groups II and IV of the periodic system of elements), or group IV materials (i.e., materials from group IV of the periodic system of elements). In some embodiments, the substrate may be non-crystalline. In some embodiments, the support 102 may be a printed circuit board (PCB) substrate, a package substrate, an interposer, a wafer, or a die. Although a few examples of materials from which the support 102 may be formed are described here, any material that may serve as a foundation upon which an IC including a double-height cell for enhanced performance as described herein may be built falls within the spirit and scope of the present disclosure. Although only one nanoribbon 104 is shown in FIG. 1, the IC structure 100 may include a stack of such nanoribbons where a plurality of nanoribbons 104 are stacked above one another. For example, FIGS. 2, 3A-3B, 4, 5A-5C, and 6 show IC structures that may be or include examples of the IC structure 100. In some embodiments, a portion of the support 102 right below the lowest nanoribbon 104 of the stack may be shaped as a subfin extending away from a base, as is known in the field of nanoribbon transistors.

The nanoribbon 104 may take the form of a nanowire or nanoribbon, for example. In some embodiments, an area of a transversal cross-section of the nanoribbon 104 (i.e., an area in the x-z plane of an x-y-z coordinate system shown in FIG. 1, perpendicular to a longitudinal axis 120 of the nanoribbon 104) may be between about 25 and 10000 square nanometers, including all values and ranges therein (e.g., between about 25 and 1000 square nanometers, or between about 25 and 500 square nanometers). In some embodiments, a width 131 of the nanoribbon 104 (i.e., a dimension measured in a plane parallel to the support 102 and in a direction perpendicular to the longitudinal axis 120 of the nanoribbon 104, e.g., along the x-axis of the coordinate system) may be at least about 3 times larger than a height or thickness of the nanoribbon 104 (i.e., a dimension measured in a plane perpendicular to the support 102, e.g., along the z-axis of the coordinate system), including all values and ranges therein, e.g., at least about 4 times larger, or at least about 5 times larger. Although the nanoribbon 104 illustrated in FIG. 1 is shown as having a rectangular cross-section, the nanoribbon 104 may instead have a cross-section that is rounded at corners or otherwise irregularly shaped, and the gate stack 106 may conform to the shape of the nanoribbon 104. The term "face" of a nanoribbon may refer to the side of the nanoribbon 104 that is larger than the side perpendicular to it (when measured in a plane substantially perpendicular to the longitudinal axis 120 of the nanoribbon 104), the latter side being referred to as a "sidewall" of a nanoribbon.

In various embodiments, the semiconductor material of the nanoribbon 104 may be composed of semiconductor material systems including, for example, N-type or P-type materials systems. In some embodiments, the nanoribbon 104 may include a high mobility oxide semiconductor material, such as tin oxide, antimony oxide, indium oxide, indium tin oxide, titanium oxide, zinc oxide, indium zinc oxide, gallium oxide, titanium oxynitride, ruthenium oxide, or tungsten oxide. In some embodiments, the nanoribbon 104 may include a combination of semiconductor materials. In some embodiments, the nanoribbon 104 may include a monocrystalline semiconductor, such as silicon (Si) or germanium (Ge). In some embodiments, the nanoribbon 104 may include a compound semiconductor with a first sub-lattice of at least one element from group III of the periodic table (e.g., Al, Ga, In), and a second sub-lattice of at least one element of group V of the periodic table (e.g., P, As, Sb).

For some example N-type transistor embodiments (i.e., for the embodiments where the transistor 110 is an N-type metal-oxide-semiconductor (NMOS) transistor), the channel material of the nanoribbon 104 may include a III-V material having a relatively high electron mobility, such as, but not limited to InGaAs, InP, InSb, and InAs. For some such embodiments, the channel material of the nanoribbon 104 may be a ternary III-V alloy, such as InGaAs, GaAsSb, InAsP, or InPSb. For some InₓGa₁₋ₓAs fin embodiments, In content (x) may be between 0.6 and 0.9, and may advantageously be at least 0.7 (e.g., In_{0.7}Ga_{0.3}As). For some example P-type transistor embodiments (i.e., for the embodiments where the transistor 110 is a P-type metal-oxide-semiconductor (PMOS) transistor), the channel material of the nanoribbon 104 may advantageously be a group IV material having a high hole mobility, such as, but not limited to Ge or a Ge-rich SiGe alloy. For some example embodiments, the channel material of the nanoribbon 104 may have a Ge content between 0.6 and 0.9, and advantageously may be at least 0.7.

In some examples, nanoribbons of the same semiconductor material may be used to form NMOS and PMOS transistors. In such examples, the NMOS and PMOS transistors may be differentiated by depositing N-type or P-type work function metals around channel portions of those transistors.

In some embodiments, the channel material of the nanoribbon 104 may be a thin-film material, such as a high mobility oxide semiconductor material, such as tin oxide, antimony oxide, indium oxide, indium tin oxide, titanium oxide, zinc oxide, indium zinc oxide, indium gallium zinc oxide (IGZO), gallium oxide, titanium oxynitride, ruthenium oxide, or tungsten oxide. In general, if the transistor formed in the nanoribbon is a thin-film transistor (TFT), the channel material of the nanoribbon 104 may include one or more of tin oxide, cobalt oxide, copper oxide, antimony oxide, ruthenium oxide, tungsten oxide, zinc oxide, gallium oxide, titanium oxide, indium oxide, titanium oxynitride, indium tin oxide, indium zinc oxide, nickel oxide, niobium oxide, copper peroxide, IGZO, indium telluride, molybdenite, molybdenum diselenide, tungsten diselenide, tungsten disulfide, Nor P-type amorphous or polycrystalline silicon, germanium, indium gallium arsenide, silicon germanium, gallium nitride, aluminum gallium nitride, indium phosphite, and black phosphorus, each of which may possibly be doped with one or more of gallium, indium, aluminum, fluorine, boron, phosphorus, arsenic, nitrogen, tantalum, tungsten, and magnesium, etc. In some embodiments, the channel material of the nanoribbon 104 may have a thickness between about 5 and 75 nanometers, including all values and ranges therein. In some embodiments, a thin-film channel material may be deposited at relatively low temperatures, which allows depositing the channel material within the thermal budgets imposed on back-end fabrication to avoid damaging other components, e.g., front-end components such as the logic devices.

A gate stack 106 including a gate electrode material 108 and, optionally, a gate insulator material 112, may wrap entirely or almost entirely around a portion of the nanoribbon 104 as shown in FIG. 1, with the active region (channel region) of the channel material of the transistor 110 corresponding to the portion of the nanoribbon 104 wrapped by the gate stack 106. As shown in FIG. 1, the gate insulator material 112 may wrap around a transversal portion of the nanoribbon 104 and the gate electrode material 108 may wrap around the gate insulator material 112.

The gate electrode material 108 may include one or more gate electrode materials, where the choice of the gate electrode materials may depend on whether the transistor 110 is a PMOS transistor or an NMOS transistor. For a PMOS transistor, gate electrode materials that may be used in different portions of the gate electrode material 108 may include, but are not limited to, tungsten, ruthenium, palladium, platinum, cobalt, nickel, and conductive metal oxides (e.g., ruthenium oxide), conductive metal nitrides (e.g., titanium nitride). For an NMOS transistor, gate electrode materials that may be used in different portions of the gate electrode material 108 include, but are not limited to, tungsten, hafnium, zirconium, titanium, tantalum, aluminum, alloys of these metals, and carbides of these metals (e.g., hafnium carbide, zirconium carbide, titanium carbide, tantalum carbide, and aluminum carbide, titanium aluminum carbide). In one example in which both an NMOS transistor and PMOS transistor include gate electrode materials that include tungsten, the gate electrode material including tungsten for the NMOS transistor may include fluorine, and the gate electrode material including tungsten for the PMOS transistor may be fluorine-free (e.g., fluorine may be substantially absent from a gate electrode material including tungsten for a PMOS transistor). In some embodiments, the gate electrode material 108 may include a stack of a plurality of gate electrode materials, where zero or more materials of the stack are workfunction (WF) materials and at least one material of the stack is a fill metal layer. Further materials/layers may be included next to the gate electrode material 108 for other purposes, such as to act as a diffusion barrier layer or/and an adhesion layer.

In some embodiments, the gate insulator material 112 may include one or more high-k dielectrics including any of the materials discussed herein with reference to the insulator material that may surround portions of the transistor 110. In some embodiments, an annealing process may be carried out on the gate insulator material 112 during fabrication of the transistor 110 to improve the quality of the gate insulator material 112. The gate insulator material 112 may have a thickness that may, in some embodiments, be between about 0.5 nanometers and 3 nanometers, including all values and ranges therein (e.g., between about 1 and 3 nanometers, or between about 1 and 2 nanometers). In some embodiments, the gate stack 106 may be surrounded by a gate spacer, not shown in FIG. 1. Such a gate spacer would be configured to provide separation between the gate stack 106 and S/D contacts of the transistor 110 and could be made of a low-k dielectric material, some examples of which have been provided below.

Turning to the S/D regions 114 of the transistor 110, in some embodiments, the S/D regions may be highly doped, e.g., with dopant concentrations of about 10²¹ cm⁻³, in order to advantageously form Ohmic contacts with the respective S/D contacts (not shown in FIG. 1), although these regions may also have lower dopant concentrations and may form Schottky contacts in some implementations. Irrespective of the exact doping levels, the S/D regions of a transistor are the regions having dopant concentration higher than in other regions, e.g., higher than a dopant concentration in the transistor channel (i.e., in a channel material extending between the first S/D region 114-1 and the second S/D region 114-2), and, therefore, may be referred to as "highly doped" (HD) regions. The channel portions of transistors typically include semiconductor materials with doping concentrations significantly smaller than those of the S/D regions 114.

The S/D regions 114 of the transistor 110 may generally be formed using either an implantation/diffusion process or an etching/deposition process. In the former process, dopants such as boron, aluminum, antimony, phosphorous, or arsenic may be ion-implanted into the nanoribbon 104 to form the source and drain regions. An annealing process that activates the dopants and causes them to diffuse further into the nanoribbon 104 may follow the ion implantation process. In the latter process, portions of the nanoribbon 104 may first be etched to form recesses at the locations of the future S/D regions 114. An epitaxial deposition process may then be carried out to fill the recesses with material that is used to fabricate the S/D regions 114. In some implementations, the S/D regions 114 may be fabricated using a silicon alloy such as silicon germanium or silicon carbide. In some implementations, the epitaxially deposited silicon alloy may be doped in situ with dopants such as boron, arsenic, or phosphorous. In further embodiments, the S/D regions 114 may be formed using one or more alternate semiconductor materials such as germanium or a group III-V material or alloy. And in further embodiments, one or more layers of metal and/or metal alloys may be used to form the S/D regions 114. In some embodiments, a distance between the first and second S/D regions 114 (i.e., a dimension measured along the longitudinal axis 120 of the nanoribbon 104) may be between about 5 and 40 nanometers, including all values and ranges therein (e.g., between about 22 and 35 nanometers, or between about 20 and 30 nanometers).

The IC structure 100 shown in FIG. 1, as well as IC structures shown in other drawings of the present disclosure, is intended to show relative arrangements of some of the components therein, and the IC structure 100, or portions thereof, may include other components that are not illustrated (e.g., electrical contacts to the S/D regions 114 of the transistor 110, additional layers such as a spacer layer around the gate electrode of the transistor 110, etc.). For example, although not specifically illustrated in FIG. 1, a dielectric spacer may be provided between a first S/D contact (which may also be referred to as a "first S/D electrode") coupled to a first S/D region 114-1 of the transistor 110 and the gate stack 106 as well as between a second S/D contact (which may also be referred to as a "second S/D electrode") coupled to a second S/D region 114-2 of the transistor 110 and the gate stack 106 in order to provide electrical isolation between the source, gate, and drain electrodes. In another example, although not specifically illustrated in FIG. 1, at least portions of the transistor 110 may be surrounded in an insulator material, such as any suitable interlayer dielectric (ILD) material. In some embodiments, such an insulator material may be a high-k dielectric including elements such as hafnium, silicon, oxygen, titanium, tantalum, lanthanum, aluminum, zirconium, barium, strontium, yttrium, lead, scandium, niobium, and zinc. Examples of high-k materials that may be used for this purpose may include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, tantalum oxide, tantalum silicon oxide, lead scandium tantalum oxide, and lead zinc niobate. In other embodiments, the insulator material surrounding portions of the transistor 110 may be a low-k dielectric material. Some examples of low-k dielectric materials include, but are not limited to, silicon dioxide, carbon-doped oxide, silicon nitride, organic polymers such as perfluorocyclobutane or polytetrafluoroethylene, fused silica glass (FSG), and organosilicates such as silsesquioxane, siloxane, or organosilicate glass.

FIG. 2 is a top-down plan view of an example of an IC structure including a double-height cell. A number of elements referred to in the description of FIGS. 2, 3A-3B, 4, 5A-5C, and 6 with reference numerals are illustrated in these drawings with different patterns, with a legend showing the correspondence between the reference numerals and patterns being provided at the bottom of each drawing page containing FIGS. 2, 3A-3B, 4, 5A-5C, and 6. For example, the legend illustrates that FIG. 2 uses different patterns to show an N-type nanoribbon 204 and a P-type nanoribbon 202, and so on.

According to one example, a single height cell may include an IC structure from one power rail to an adjacent power rail, and a double-height cell may include the space between/spanning three adjacent power rails. A triple-height cell may include the space between/spanning four adjacent power rails. For example, the IC structure 200 includes a double-height cell with three rails, two of which are labeled M0/VDD and another rail labeled M0/VSS between the two VDD rails. The VDD and VSS rails in FIG. 2 run or extend along the y-axis. In the example illustrated in FIG. 2, the label M0/VDD indicates that the power rails are configured to deliver a voltage VDD in a metal 0 layer and the label M0/VSS indicates that the power rail is configured to deliver a voltage VSS or ground in a metal 0 layer. Power rails (which may also be referred to as voltage rails) are conductive interconnects configured to couple with a power/voltage source or ground. Metal layer 0 may be a first metal layer of a metallization stack (e.g., the lowest metal layer of a frontside metallization stack). Additional metal layers can be formed on top of M0, and these metal layers are typically referred to as M1, M2, and so on. In the example illustrated in FIG. 2, in addition to the power rails, other metal 0 lines are present between and extending parallel to the power rails.

The IC structure 200 also includes metal 1 (M1) lines extending orthogonally to the M0 lines. FIG. 2 depicts two M1 lines extending along the x-axis shown in FIG. 2. Metal lines in a layer of a metallization stack often extend orthogonally to the lines in the layer immediately above or below the layer; however, in other examples, a metal layer may have lines that are parallel to the lines in an adjacent layer instead of, or in addition to, orthogonal metal lines. In the example illustrated in FIG. 2, the IC structure 200 also includes via contact rails 216, which may be conductive elements between and coupled with (e.g., in contact with, e.g., in direct contact with) a conductive contact below the metallization stack (such as an S/D contact structure) and a conductive element of the metallization stack, such as a line or via (e.g., of metal layer 0). For example, the via contact rails 216 may be between and coupled with an S/D contact and a power rail in M0. The via contact rails 216 may be conductive structures such as elongated vias that are substantially aligned with and parallel to a metal line, such as M0/VDD or M0/VSS. The via contact rails 216 may effectively increase the depth/height of the power rail, which may reduce the resistance in the power rail. As the trend in IC technology has been to shrink feature sizes (including metal line pitch and width), the via contact rails 216 may offset the impact to resistance resulting from narrower power rails.

The IC structure 200 illustrated in FIG. 2 also includes four diffusion regions, which are illustrated as two N-type nanoribbons 204 and two P-type nanoribbons 202 extending parallel to one another along the y-axis as shown in FIG. 2. The nanoribbons 202, 204 may represent stacks of nanoribbons stacked over one another (e.g., two nanoribbons stacked over one another, three nanoribbons stacked over one another, four nanoribbons stacked over one another, etc.). The two N-type nanoribbons 204 are adjacent to one another, and the two P-type nanoribbons 202 are shown on the top and bottom of FIG. 2 on either side of the pair of N-type nanoribbons 204. The following description refers to the nanoribbons 204 as N-type nanoribbons that form the basis of NMOS transistors and the nanoribbons 202 as P-type nanoribbons that form the basis of PMOS transistors. In some examples, the N-type and P-type nanoribbons 204, 202 may have a different material composition, different gate electrode material, and/or other different properties. In some examples, the N-type and P-type nanoribbons 204, 202 may have the same or substantially the same material composition. In one such example, the NMOS and PMOS transistors may be distinguished from one another based on the presence of one or more different gate electrode materials in their respective gate stacks.

Metal gate lines 212 and S/D contact lines 213 may extend substantially perpendicular to the nanoribbons 202 and 204 and substantially parallel to one another, e.g., along the x-axis shown in FIG. 2. FIG. 2 illustrates that the metal gate lines 212 and the S/D contact lines 213 may be provided in an alternating manner. Metal gate lines 212 may intersect gate contacts that are in conductive contact with the gate stacks 106 (not visible in the view of FIG. 2) provided over channel portions of the nanoribbons 202 and 204, providing electrical connectivity to the gates of the nanoribbon transistors. Thus, portions of the gate contacts intersecting the gate stacks 106 are in conductive contact with the gate stacks 106 and serve as gate contacts for the transistors. Similarly, S/D contact lines 213 may intersect the S/D contacts provided over S/D regions 114-1, 114-2 (not visible in the view of FIG. 2) of the nanoribbons 202 and 204, providing electrical connectivity to the S/D regions 114-1, 114-2 of the nanoribbon transistors. Thus, portions of the S/D contacts intersecting the S/D regions 114-1, 114-2 are in conductive contact with the S/D regions 114-1, 114-2 and serve as S/D contacts for the transistors. Metal gate cut lines 208 indicate areas in which the metal gate lines 212 may be absent (e.g., removed) to electrically/conductively isolate the gates of adjacent transistors. Similarly, the S/D contact lines 213 may be cut in areas to electrically/conductively isolate the S/D regions of different transistors from one another.

Conductive vias 215 may couple the metal gate lines 212 with conductive lines in a metal layer (e.g., M0) over the device region of the IC structure 200. The conductive vias 210 represent vias between M0 and M1 metal layers. In some places, a via between an S/D contact line 213 and M0 may be present below the conductive vias 210. One or more isolation lines or regions (not shown in FIG. 2) may also be present in the IC structure 200. In one example, such isolation lines may be substantially parallel with the metal gate lines 212 and substantially orthogonal to the nanoribbons 202 and 204 to isolate adjacent transistors in the same nanoribbon from one another.

The IC structure 200 illustrates an example of an inverter circuit including two legs (e.g., two inverters in parallel) implemented with a double-height cell. For example, the inverter circuit includes two PMOS transistors in parallel coupled with two NMOS transistors in parallel. The approximate location of the source regions, drain regions, and gates of the transistors are indicated with the labels "SX", "DX", and "GX", where "X" indicates the number of the transistor. For example, the source region of the first transistor (which in this example is a PMOS transistor) is labeled S1, the drain region of the first transistor is labeled D1, and the gate region of the first transistor is labeled "G1". Similarly, the source region of the second transistor (which in this example is an NMOS transistor) is labeled S2, and so forth. In order to implement an inverter circuit, the gates G1, G2, G3, and G4 are coupled with an input. For example, the gates G1, G2, G3, and G4 are coupled with a metal gate line 212, which is coupled with vias 215. The vias 215 are between and coupled with the metal gate lines 212 and M0 lines. The M0 lines may be coupled with an M1 line through the vias 210-1 and 210-2.

The source region S1 of the first PMOS transistor and the source region S4 of the second PMOS transistor are coupled with a VDD rail (e.g., M0/VDD). In the example illustrated in FIG. 2, the connections between the source regions S1 and S4 and respective VDD rails are made through the via contact rails 216 between the respective S/D lines 212 and the respective M0/VDD rails. Similarly, the source region S2 of the first NMOS transistor and the source region S3 of the second NMOS transistor are coupled with a VSS rail (e.g., M0/VSS). In the example illustrated in FIG. 2, the connections between the source regions S2 and S3 and the VSS rail are made through the via contact rail 216 between the respective S/D lines 212 and the M0/VSS rail.

The drain regions D1, D2, D3, and D4 are coupled together and represent an output of the circuit. For example, the drain regions D1 and D2 are coupled together via an S/D line 213 and the drain regions D3 and D4 are coupled together via another S/D line 213. The vias 210-3 and 210-4 are between and coupled with an M0 line and an M1 line. Additional vias between the M0 line and the S/D line 213 may be present in the locations of the vias 210-3 and 210-4. In order to couple the drain regions D1 and D2 with the drain regions D3 and D4, interconnects in a higher metal layer (e.g., M1 lines) are used to avoid shorting to the via contact rail 216 below and coupled with the power rail M0/VSS. However, using M1 interconnects to couple the drain regions may increase the capacitance of the cell.

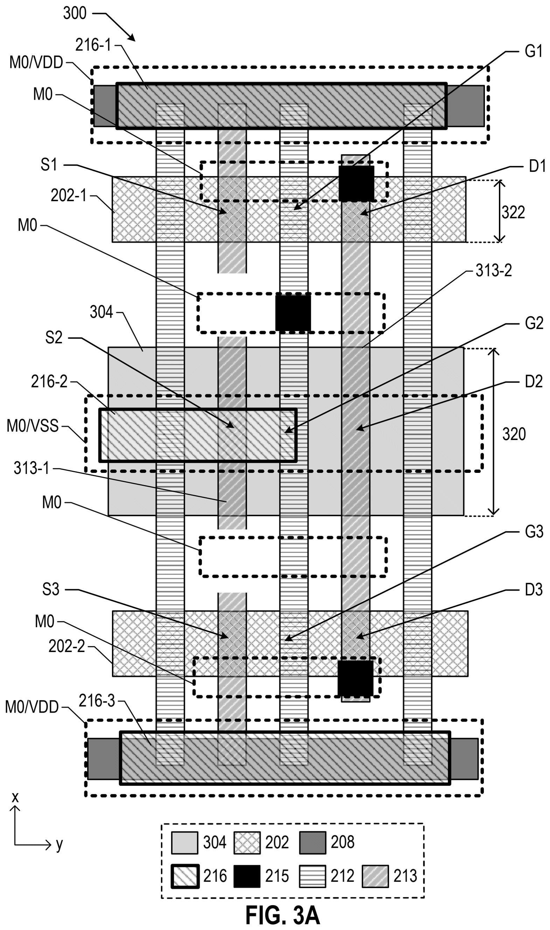

In contrast, the IC structure 300 of FIG. 3A includes transistors to implement an inverter circuit in a double-height cell in which the drain regions are coupled with an S/D line instead of through M1. Like the IC structure 200 in FIG. 2, the IC structure 300 includes two P-type nanoribbons 202. However, instead of including two N-type nanoribbons 204, the IC structure 300 includes a single wider N-type nanoribbon 304. For example, the nanoribbon 304 of FIG. 3A has a width 320 that is greater than the width 322 of the nanoribbons 202. In some examples, the nanoribbon 304 of FIG. 3A may occupy the same area of two nanoribbons (e.g., the two nanoribbons 204 of FIG. 2), and may therefore be considered a "merged" nanoribbon. In some examples, the width 320 of the nanoribbon 304 may be about the same as the combined width of two narrower nanoribbons (e.g., the nanoribbons 204) and the space between those nanoribbons. For example, the width 320 may be greater than or equal to about two times the width 322. In some examples in which a dielectric spine is present between and coupled with two narrower nanoribbons, the width 320 of the nanoribbon 304 may be about the same as the combined width of the two narrower nanoribbons and the width of the dielectric spine.

Thus, one difference between the IC structures 200 and 300 is that the IC structure 300 includes a wide N-type nanoribbon 304. Another difference between the IC structures 200 and 300 is that the IC structure 300 includes a power rail (in this example M0/VSS) over and substantially aligned with the nanoribbon 304. For example, due to the greater width of the nanoribbon 304, the power rail VSS may be directly over and aligned with the nanoribbon 304 instead of between adjacent nanoribbons like in the IC structure 200 of FIG. 2. Additionally, due to the larger width of the nanoribbon 304, a metal gate cut line 208 is absent from below the power rail that is over the wide nanoribbon 304. For example, as can be seen in FIG. 3A, there are metal gate cut lines 208 below the M0/VDD rails, but there is no metal gate cut line 208 below the M0/VSS rail. Another difference between the IC structures 200 and 300 is that the via contact rail 216-2 under the power rail aligned with the wide nanoribbon 304 is shorter than the via contact rails 216-1, 216-3. For example, the via contact rail 216-2 is discontinued under the metal gate line 212 so that the via contact rail 216-2 is absent in the region with the S/D line 213 over the nanoribbon 304. Thus, the length of the via contact rail 316-2 is shorter than the length of the power rail that it is coupled with. In some examples, the length of the 316-2 depends on factors such as the dimensions (e.g., width and spacing/pitch) of the metal gate lines 212. For example, where the metal gate lines 212 have a pitch, where the pitch is a measurement of the distance between an approximate middle of one metal gate line 212 and the approximate middle of an adjacent metal gate line 212. In order to not contact an S/D line connecting two S/D regions, the length of the via contact rail 316-2 may be smaller than about 1.5 times the pitch of the metal gate lines 212 (e.g., between about 1 and 1.5 times the pitch of the metal gate lines 212). The width of the via contact rail 316-2 may be smaller than or about equal to the width of the power rail with which it is coupled. In some examples, the via contact rail 316-2 may have about the same width as the power rail. In other examples, the via contact rail 316-2 may have a smaller width than the power rail (e.g., about 4-5 nanometers smaller, as an example). The S/D line 313-1 coupled with the source region S2 is between and coupled with the source region S2 and the via contact rail 216-2, the S/D line 313-2, which is coplanar with the S/D line 313-1, includes a continuous conductive material between and coupled with the first drain region D1, the second drain region D2, and the third drain region D3, where the S/D line 313-2 extends below and substantially orthogonally to the power rail M0/VSS without contacting the power rail M0/VSS due to the absence of the via contact rail 216-2 in that region.

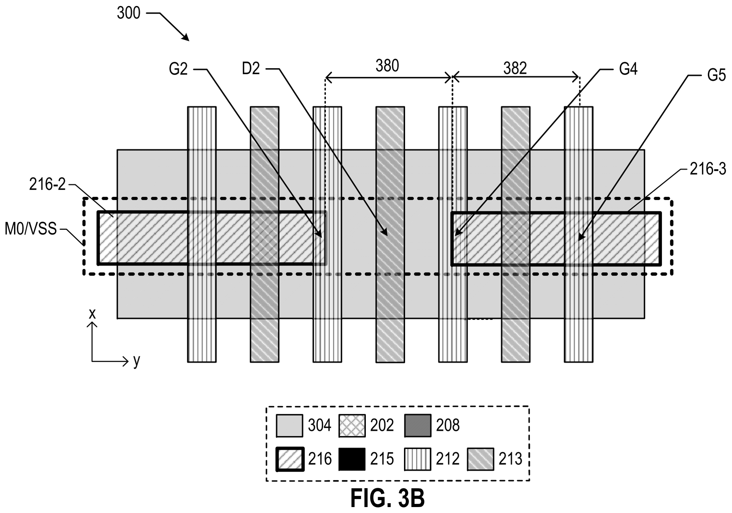

In another aspect, the via contact rail 216-2 may be patterned such that the discontinuity or gap in a drain region may have a length that is about the same as the distance between two adjacent metal gate lines or the pitch of the metal gate lines. For example, FIG. 3B illustrates another view of a portion of the IC structure 300 shown in FIG. 3A. As can be seen in FIG. 3B, the metal gate lines 212 have a pitch 382, where the pitch of the metal gate lines 212 is a measurement of distance between an approximate center of a metal gate line and an approximate center of an adjacent metal gate line. As can be seen in FIG. 3B, two via contact rails 216-2 and 216-3 (which may also be considered two separate portions of the same via contact rail) are separated by a distance 380, which is about the same as the pitch 382. Although only two via contact rails 216-2 and 216-3 are shown in FIG. 3B, the pattern may continue across multiple metal gate lines 212 and S/D lines 213 such that the via contact rail is absent in areas over drain regions to allow for an S/D line 213 to pass under the voltage rail (e.g., M0/VSS in the example shown in FIG. 3B) to couple two drain regions without shorting to the via contact rail.

Thus, the circuit illustrated in FIGS. 3A-3B illustrate an example of an IC structure 300 implementing an inverter circuit in a double-height cell, where the IC structure includes a first transistor with a first channel region in a first nanoribbon 202-1 of a semiconductor material, a second transistor with a second channel region in a second nanoribbon 304 coplanar with, adjacent to, and parallel with the first nanoribbon, a third transistor with a third channel region in a third nanoribbon 202-2 coplanar with, adjacent to, and parallel with the second nanoribbon 304. The IC structure further includes a conductive contact structure (e.g., the S/D line 313-2) comprising a continuous conductive material extending substantially orthogonally to the first nanoribbon 202-1 and coupled with a first drain region D1 of the first transistor, a second drain region D2 of the second transistor, and a third drain region D3 of the third transistor, where the conductive contact structure is below the M0 lines.

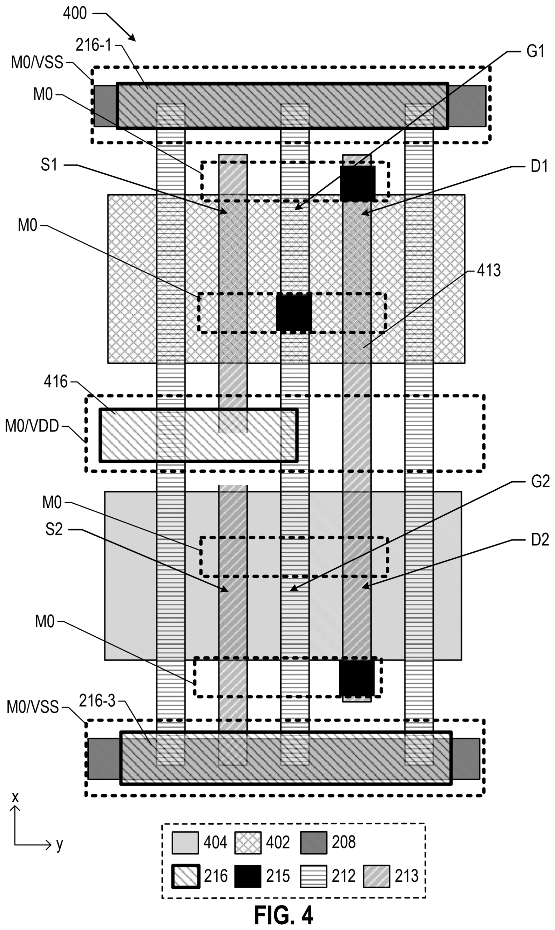

FIG. 4 is a top-down plan view of another example of an IC structure 400 including a transistor arrangement in a double-height cell and a partial via contact rail under a power rail. The IC structure 400 of FIG. 4 is another example of an inverter circuit implemented in a double-height cell. The IC structure 400 is similar to the IC structure 300, except that the IC structure 400 includes two wide nanoribbons 402, 404, unlike the IC structure 300 that includes one wide nanoribbon 304 between two narrower nanoribbons 202. Specifically, the IC structure 400 includes a P-type nanoribbon 402 and an N-type nanoribbon 404. The inverter circuit implemented with the transistor arrangement in FIG. 4 includes one NMOS transistor with a channel region in a wide N-type nanoribbon 404 and one PMOS transistor with a channel region in a wide P-type nanoribbon 402.

In the example illustrated in FIG. 4, the power rail M0/VDD is not directly over and aligned with a nanoribbon. Instead, in the example shown in FIG. 4, the M0/VDD power rail is between the nanoribbon 402 and the nanoribbon 404. Like in FIG. 3A, the via contact rail 416 is a partial via contact rail that is patterned such that it is not directly over the path of the S/D line 413 that connects drain regions D1 and D2. For example, the conductive via contact rail 416 is selectively discontinued (under the metal gate line 212 in the example of FIG. 4) to prevent electrical shorting between the drain connection and the via contact rail 416. This allows the S/D line 413 to pass under the voltage rail (e.g., M0/VDD in the example of FIG. 4) without interference, enabling direct coupling of NMOS and PMOS drain regions D1 and D2.

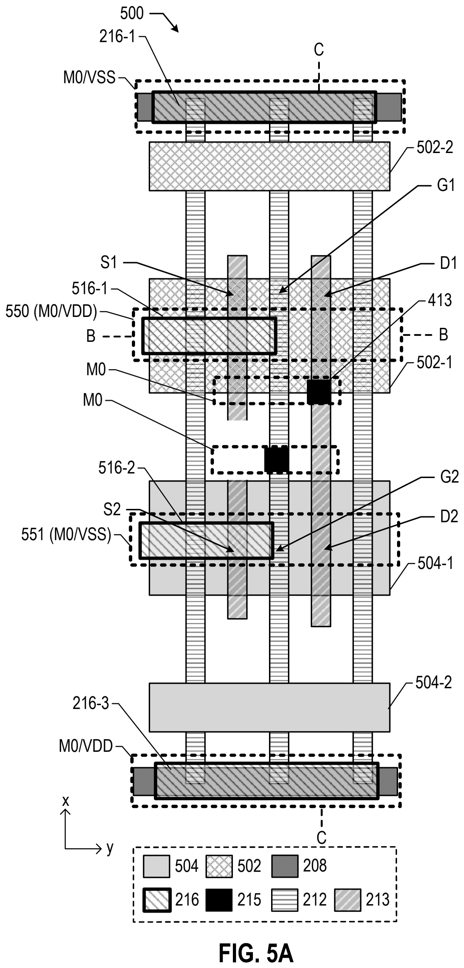

FIG. 5A is a top-down plan view of an example of an IC structure 500 including a transistor arrangement in a triple-height cell and a partial via contact rail under a power rail. The IC structure 500 includes N-type nanoribbons 504 and P-type nanoribbons 502. The IC structure 500 of FIG. 5A is similar to the IC structure 400 of FIG. 4 in that it includes an inverter circuit implemented with two transistors, one NMOS transistor with a channel region in the wide N-type nanoribbon 504-1 and one PMOS transistor with a channel region in the wide P-type nanoribbon 502-1. The arrangement illustrated in FIG. 5A differs in that one of the power rails 550 (M0/VDD) is directly over and aligned with the wide P-type nanoribbon 502-1 and one of the power rails 551 (M0/VSS) is directly over and aligned with the wide N-type nanoribbon 504-1. The IC structure 500 also includes two "dummy" nanoribbons 502-2 and 504-2. Thus, the IC structure 500 lacks active transistors in the dummy portions of the nanoribbons 502-2 and 504-2. In one example, the dummy nanoribbons 502-2 and 504-2 may be conductively/electrically isolated from a power rail and/or signal lines in the metallization stack.

In the example shown in FIG. 5A, the IC structure 500 includes partial via contact rails 516-1 and 516-2 below the power rails coupled with the source regions S1 and S2. For example, the via contact rail 516-1 is present between the source region S1 and the power rail 550 (M0/VDD) and is absent over the drain region D1. Similarly, the via contact rail 516-2 is present between the source region S2 and the power rail 551 (M0/VSS) and is absent over the drain region D2.

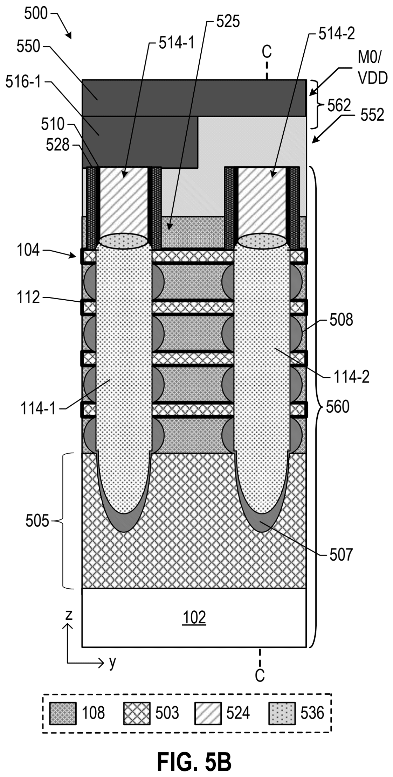

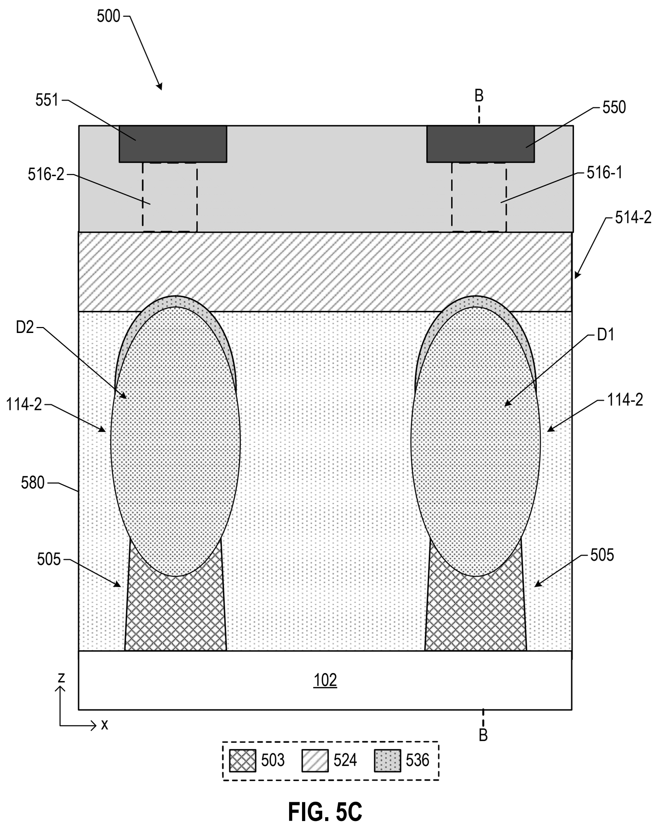

FIGS. 5B and 5C illustrate different cross-sectional views of the IC structure 500 of FIG. 5A. Specifically, FIG. 5B illustrates a cross-sectional side view along a plane BB shown in FIG. 5A, and FIG. 5C illustrates a cross-sectional side view along a plane CC shown in FIG. 5A.

The portion of the IC structure 500 illustrated in FIG. 5B includes a transistor in a device region 560 similar to the transistor 110 of FIG. 1 but built on the basis of a nanoribbon stack 525 of a plurality of nanoribbons 104 instead of just one nanoribbon 104 as shown in FIG. 1. While four nanoribbons 104 are shown to be included in the nanoribbon stack 525, in other embodiments, fewer nanoribbons 104 or more nanoribbons 104 may be included. FIG. 5B illustrates a semiconductor material 503 as the material of the nanoribbons 104, further illustrating a subfin 505 of the semiconductor material 503 below the nanoribbon stack 525 although in some embodiments the nanoribbons 104 and at least a portion of the subfin 505 may include semiconductor materials of different material compositions. As shown in FIG. 5B, a gate stack having a gate insulator material 112 and a gate electrode material 108 may wrap around channel portions of the nanoribbons 104. FIG. 5B further illustrates a first S/D region 114-1 and a second S/D region 114-2 extending through the nanoribbon stack 525, electrically insulated/separated from the gate electrode material 108 and from the semiconductor material 503 of the subfin 505 by an insulator material 507. In some embodiments, the insulator material 507 may form so-called "dimples" 508 in areas where the insulator material 507 separates the S/D regions 114-1, 114-2 from the gate electrode material 108. The insulator material 507 may include any of the insulator materials described herein, e.g., any of the ILD materials described above.

Above the nanoribbon stack 525, FIG. 5B illustrates a gate contact 506 and S/D contacts on either side of the gate contact 506, individually labeled as a first S/D contact 514-1 for making electrical contact to the first S/D region 114-1 and a second S/D contact 514-2 for making electrical contact to the second S/D region 114-2. The S/D contacts 514-1, 514-2 may represent portions of the S/D contact lines 213 shown in FIG. 5A. In the example illustrated in FIG. 5B, a gate contact is not present below the via contact rail 516-1, but is present in another cross-section where the via contact rail 516-1 is absent. The gate contact may include an electrically conductive material in electrically conductive contact with the gate electrode material 108. In various embodiments, material compositions of the electrically conductive material and the gate electrode material 108 may be substantially the same or different.

The S/D contacts 514-1, 514-2 may be electrically isolated from the gate electrode material 108 and the electrically conductive material 526 of the gate contact 506 by gate spacers 528. The gate spacers 528 may include one or more of spacer materials, diffusion barrier materials, adhesion materials, etc., as known in the art for forming contacts to various components of IC structures. In some embodiments, the gate spacers 528 may include low-k dielectrics and/or any of the ILD materials described above. Optionally, sidewalls of the S/D contacts 514-1, 514-2 may be lined with one or more liners 510, where the liners 510 may include, but not limited to, materials comprising silicon and nitrogen (e.g., silicon nitride), materials comprising silicon and oxygen (e.g., silicon oxide), materials comprising silicon and carbon (e.g., silicon carbide), and/or their composites. Within the sidewalls, the S/D contacts 514-1, 514-2 may be filled with an electrically conductive fill material 524. In various embodiments, material compositions of the electrically conductive fill material 524 and the electrically conductive material 526 may be substantially the same (e.g., both may include/be tungsten) or different. At the bottom of the S/D contacts 514-1, 514-2, an interface material 536 is deposited to provide an interface between the S/D regions 114-1, 114-2 and the electrically conductive fill material 524 of S/D contacts 514-1, 514-2. The interface material 536 may include/be a metal such as titanium which, once deposited, may intermix with the material of the S/D regions 114-1, 114-2, e.g., with silicon, forming a compound (e.g., titanium silicide) that may help reduce contact resistance of the S/D contacts 514-1, 514-2. In other embodiments, the interface material 536 is optional and may be absent from the bottom and/or absent from the side walls of the S/D contacts 514-1, 514-2.

The view depicted in FIG. 5B also shows a portion of a metallization stack 562 over the device region 560, where the metallization stack comprises a power rail 550. The IC structure 500 also includes a conductive structure (e.g., via contact rail 516-1) below, extending parallel with, and in contact with the power rail 550. The via contact rail 516-1 may include any suitable conductive material, such as one or more of: tungsten, ruthenium, cobalt, and/or any other suitable conductive material. The S/D contact 514-1 is between the S/D region 114-1 and the via contact rail 516-1. The other S/D contact 514-2 (which is coplanar with the S/D contact 514-1) may extend between and couple with the S/D region 114-2 and another S/D region, such as shown in FIG. 5A. The S/D contact 514-2 may thus extend below and substantially orthogonally to the power rail 550. An insulator material 552 that is coplanar with the via contact rail 516-1 is between the S/D contact 514-2 and the power rail 550 (e.g., at an intersection between the S/D contact 514-2 and the power rail 550, i.e., the region where the power rail 550 passes over the S/D contact 514-2), which electrically/conductively isolates the S/D contact 514-2 from the power rail 550. Note that although FIG. 5B illustrates the via contact rail 516-1 with the same shading as the power rail 550 and with different shading from the S/D contact 514-1, the via contact rail 516-1 may have substantially the same material composition as the power rail 550 or the S/D contact 514-1, or a different material composition from the power rail 550 and/or the S/D contact 514-1. In one example, the via contact rail 516-1 has the same material composition as the S/D contact 514-1 (e.g., tungsten or a different conductive material), and a different material composition from the power rail 550. In one such example, a liner may be present between the S/D contact 514-1 and the via contact rail 516-1 (e.g., a liner of a different conductive material than that filling the S/D contact 514-1).

FIG. 5C provides another illustration of the IC structure 500 along the plane CC shown in FIGS. 5A and 5B (i.e., a cut across S/D regions of two different nanoribbon stacks). FIG. 5C shows the plane BB along which the cut of FIG. 5B is shown.

FIG. 5C illustrates two S/D regions 114-2. The two S/D regions 114-2 are provided over/in different ones of the nanoribbons or nanoribbon stacks. For example, the nanoribbons 502-1 and 504-1 shown in FIG. 5A. FIG. 5C further illustrates an insulator material 580 that may surround the S/D regions 114-2, below the electrically conductive fill material 524 of the S/D contact 514-2, and may also surround the sidewalls of the subfins 505 of the nanoribbon stacks. The insulator material 580 may, e.g., include any of the ILD materials described above and may have either substantially the same or different material compositions with any other insulator materials in the IC structure 500.

As can be seen in FIG. 5C, the power rails 550 and 551 pass over the drain regions D1 and D2, respectively. In the cross-section shown in FIG. 5C, the power rails 550 and 551 extend along the y-axis (e.g., into and out of the page as shown in FIG. 5C). The locations where the via contact rails 516-1 and 516-2 are cut or discontinued are shown with a dashed outline in FIG. 5C. Thus, the via contact rails 516-1 and 516-2 are absent between the S/D contact 514-2 and the power rails 550 and 551, enabling the S/D contact 514-2 to pass under the rails 550 and 551.

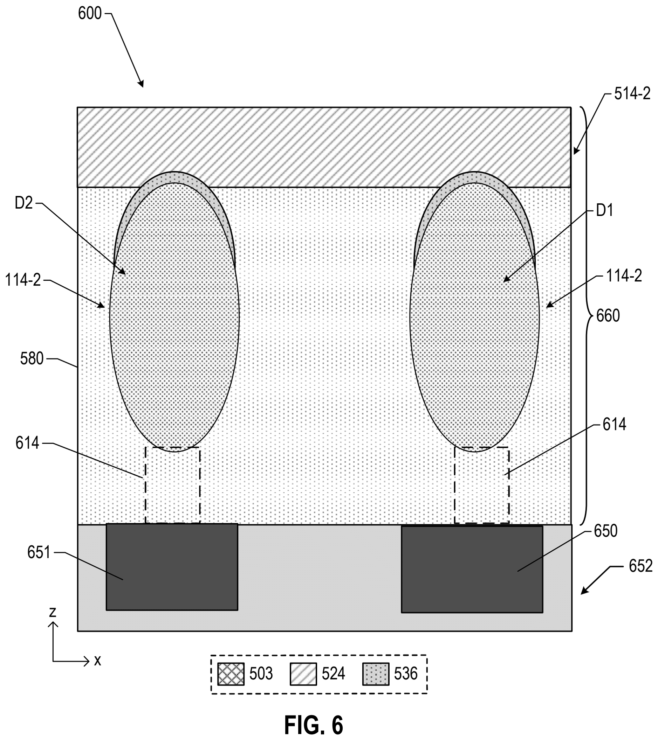

FIGS. 5A-5C show examples in which the source regions of the transistors are coupled with frontside power rails. In some examples, one or more source regions may be coupled with backside power rails. For example, FIG. 6 shows a cross-sectional side view of an example IC structure 600 with backside power rails. For example, the IC structure 600 includes a backside metallization stack 652 (e.g., backside metal layers) below the device region 660, where the second metallization stack 652 includes power rails 650 and 651 coupled with the S/D regions 114-1 (not shown in FIG. 6). The location of backside S/D contacts 614 are shown in FIG. 6, which may coupled with source regions of the transistors. The S/D contact 514-2 over the device region 660 extends between the two drain regions D1 and D2.

Thus, IC structures with double-height cells in accordance with examples described herein may enable enhanced performance without compromising on capacitance and without reducing routing resource in frontside metal layers such as M1. In one example, an IC structure includes device region with a first transistor with a first channel region, a first source region, and a first drain region, and a second transistor coplanar with and adjacent to the first transistor, where the second transistor has a second channel region, a second source region, and a second drain region. The IC structure may further include a metallization stack over the device region and a contact structure (e.g., drain contact line) below the metallization stack and including a continuous conductive material between and coupled with the first drain region and the second drain region.

IC structures IC structures with double-height cells for enhanced performance as described herein (e.g., as described with reference to FIGS. 1, 2, 3A-3B, 4, 5A-5C, and 6) may be used to implement any suitable components. For example, in various embodiments, transistors described herein may be part of one or more of: a central processing unit, a memory device (e.g., a high-bandwidth memory device), a memory cell, a logic circuit, input/output circuitry, a field programmable gate array (FPGA) component such as an FPGA transceiver or an FPGA logic, a power delivery circuitry, an amplifier (e.g., a III-V amplifier), Peripheral Component Interconnect Express (PCIE) circuitry, Double Data Rate (DDR) transfer circuitry, a computing device (e.g., a wearable or a handheld computing device), etc.

The IC structures disclosed herein, e.g., the IC structures 100, 200, 300, 400, 500, and 600, may be included in any suitable electronic component. FIGS. 7-11 illustrate various examples of apparatuses that may include the IC structures 100, 200, 300, 400, 500, and 600 disclosed herein.

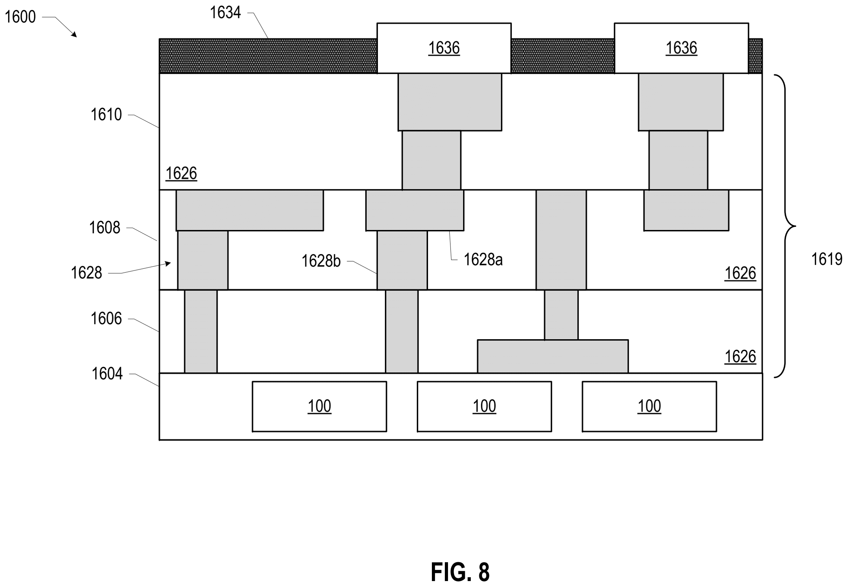

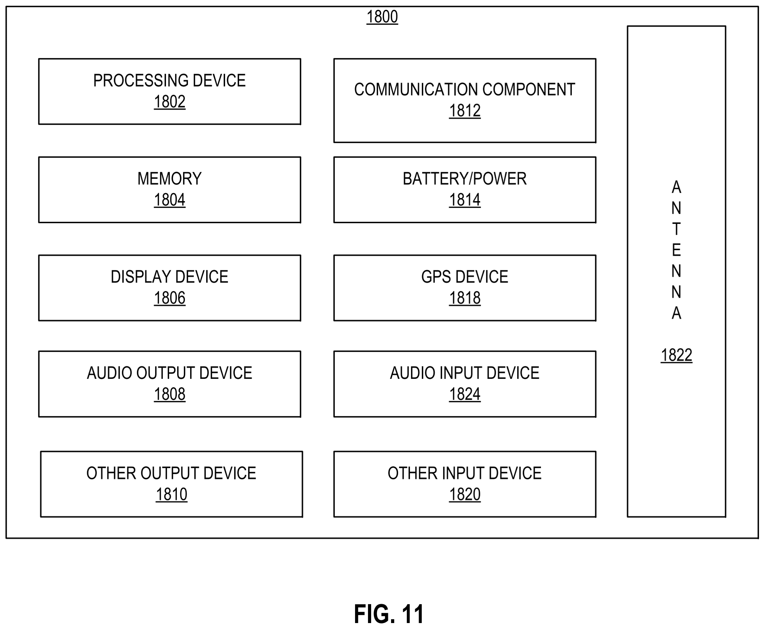

FIG. 7 is a top view of a wafer 1500 and dies 1502 that may include one or more IC structures 100, 200, 300, 400, 500, and 600 in accordance with any of the embodiments disclosed herein. The wafer 1500 may be composed of semiconductor material and may include one or more dies 1502 having IC structures formed on a surface of the wafer 1500. Each of the dies 1502 may be a repeating unit of a semiconductor product that includes any suitable IC. After the fabrication of the semiconductor product is complete, the wafer 1500 may undergo a singulation process in which the dies 1502 are separated from one another to provide discrete "chips" of the semiconductor product. The die 1502 may include one or more IC structures 100, 200, 300, 400, 500, and 600 (e.g., as discussed below with reference to FIG. 8), one or more transistors (e.g., some of the transistors of the device region 1604 of FIG. 8, discussed below, e.g., nanoribbon-based transistors of the IC structures 100, 200, 300, 400, 500, and 600) and/or supporting circuitry to route electrical signals to the transistors, as well as any other IC components. In some embodiments, the wafer 1500 or the die 1502 may include a memory device (e.g., a random-access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Multiple ones of these devices may be combined on a single die 1502. For example, a memory array formed by multiple memory devices may be formed on a same die 1502 as a processing device (e.g., the processing device 1802 of FIG. 11) or other logic that is configured to store information in the memory devices or execute instructions stored in the memory array.

FIG. 8 is a side, cross-sectional view of an IC device 1600 that may include one or more IC structures in accordance with any of the embodiments disclosed herein (e.g., in accordance with IC structures 100, 200, 300, 400, 500, and 600). One or more of the IC devices 1600 may be included in one or more dies 1502 (FIG. 7). The IC device 1600 may include a device region 1604 including one or more IC structures (e.g., one or more of IC structures 100, 200, 300, 400, 500, and 600) disclosed herein, or any variations of the IC structures. The device region 1604 may further include electrical contacts to the gates of the transistors included in the device region 1604 and to the S/D materials of the transistors included in the device region 1604 (e.g., to the S/D regions 114 of the IC structure 100).

Electrical signals, such as power and/or input/output (I/O) signals, may be routed to and/or from the devices (e.g., the transistors) of the device region 1604 through one or more interconnect layers disposed on the device region 1604 (illustrated in FIG. 8 as interconnect layers 1606-1610). For example, electrically conductive features of the device region 1604 (e.g., the gate electrode material 108 of the IC structure 100) may be electrically coupled with the interconnect structures 1628 of the interconnect layers 1606-1610. The one or more interconnect layers 1606-1610 may form a metallization stack (also referred to as an "ILD stack") 1619 of the IC device 1600.

The interconnect structures 1628 may be arranged within the interconnect layers 1606-1610 to route electrical signals according to a wide variety of designs (in particular, the arrangement is not limited to the particular configuration of interconnect structures 1628 depicted in FIG. 8). Although a particular number of interconnect layers 1606-1610 is depicted in FIG. 8, embodiments of the present disclosure include IC structures having more or fewer interconnect layers than depicted.

In some embodiments, the interconnect structures 1628 may include lines 1628a and/or vias 1628b filled with an electrically conductive material such as a metal. The lines 1628a may be arranged to route electrical signals in a direction of a plane that is substantially parallel with a surface of the support 102 upon which the device region 1604 is formed. For example, the lines 1628a may route electrical signals in a direction in and out of the page from the perspective of FIG. 8. The vias 1628b may be arranged to route electrical signals in a direction of a plane that is substantially perpendicular to the surface of the support 102 upon which the device region 1604 is formed. In some embodiments, the vias 1628b may electrically couple lines 1628a of different interconnect layers 1606-1610 together.

The interconnect layers 1606-1610 may include a dielectric material 1626 disposed between the interconnect structures 1628, as shown in FIG. 8. In some embodiments, the dielectric material 1626 disposed between the interconnect structures 1628 in different ones of the interconnect layers 1606-1610 may have different compositions; in other embodiments, the composition of the dielectric material 1626 between different interconnect layers 1606-1610 may be the same.

A first interconnect layer 1606 may be formed above the device region 1604. In some embodiments, the first interconnect layer 1606 may include lines 1628a and/or vias 1628b, as shown. The lines 1628a of the first interconnect layer 1606 may be coupled with contacts (e.g., contacts to the S/D regions 114 of the IC structure 100) of the device region 1604.

A second interconnect layer 1608 may be formed above the first interconnect layer 1606. In some embodiments, the second interconnect layer 1608 may include vias 1628b to couple the lines 1628a of the second interconnect layer 1608 with the lines 1628a of the first interconnect layer 1606. Although the lines 1628a and the vias 1628b are structurally delineated with a line within each interconnect layer (e.g., within the second interconnect layer 1608) for the sake of clarity, the lines 1628a and the vias 1628b may be structurally and/or materially contiguous (e.g., simultaneously filled during a dual-damascene process) in some embodiments.

A third interconnect layer 1610 (and additional interconnect layers, as desired) may be formed in succession on the second interconnect layer 1608 according to similar techniques and configurations described in connection with the second interconnect layer 1608 or the first interconnect layer 1606. In some embodiments, the interconnect layers that are "higher up" in the metallization stack 1619 in the IC device 1600 (i.e., farther away from the device region 1604) may be thicker.

The IC device 1600 may include a solder resist material 1634 (e.g., polyimide or similar material) and one or more conductive contacts 1636 formed on the interconnect layers 1606-1610. In FIG. 8, the conductive contacts 1636 are illustrated as taking the form of bond pads. The conductive contacts 1636 may be electrically coupled with the interconnect structures 1628 and configured to route the electrical signals of the transistor(s) of the device region 1604 to other external devices. For example, solder bonds may be formed on the one or more conductive contacts 1636 to mechanically and/or electrically couple a chip including the IC device 1600 with another component (e.g., a circuit board). The IC device 1600 may include additional or alternate structures to route the electrical signals from the interconnect layers 1606-1610; for example, the conductive contacts 1636 may include other analogous features (e.g., posts) that route the electrical signals to external components.

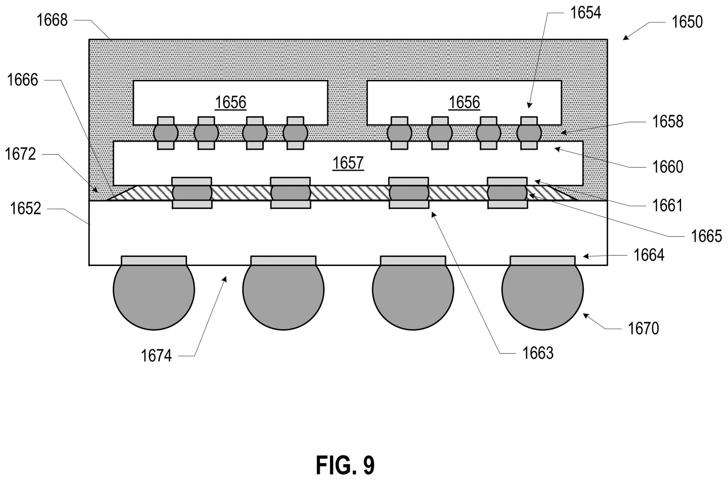

FIG. 9 is a side, cross-sectional view of an example IC package 1650 that may include one or more IC structures 100, 200, 300, 400, 500, and 600 in accordance with any of the embodiments disclosed herein. In some embodiments, the IC package 1650 may be a system-in-package (SiP).

The package substrate 1652 may be formed of a dielectric material (e.g., a ceramic, a buildup film, an epoxy film having filler particles therein, glass, an organic material, an inorganic material, combinations of organic and inorganic materials, embedded portions formed of different materials, etc.), and may have conductive pathways extending through the dielectric material between the face 1672 and the face 1674, or between different locations on the face 1672, and/or between different locations on the face 1674. These conductive pathways may take the form of any of the interconnect structures 1628 discussed above with reference to FIG. 8.

The package substrate 1652 may include conductive contacts 1663 that are coupled to conductive pathways (not shown) through the package substrate 1652, allowing circuitry within the dies 1656 and/or the interposer 1657 to electrically couple to various ones of the conductive contacts 1664 (or to devices included in the package substrate 1652, not shown).

The IC package 1650 may include an interposer 1657 coupled to the package substrate 1652 via conductive contacts 1661 of the interposer 1657, first-level interconnects 1665, and the conductive contacts 1663 of the package substrate 1652. The first-level interconnects 1665 illustrated in FIG. 9 are solder bumps, but any suitable first-level interconnects 1665 may be used. In some embodiments, no interposer 1657 may be included in the IC package 1650; instead, the dies 1656 may be coupled directly to the conductive contacts 1663 at the face 1672 by first-level interconnects 1665. More generally, one or more dies 1656 may be coupled to the package substrate 1652 via any suitable structure (e.g., a silicon bridge, an organic bridge, one or more waveguides, one or more interposers, wirebonds, etc.).

The IC package 1650 may include one or more dies 1656 coupled to the interposer 1657 via conductive contacts 1654 of the dies 1656, first-level interconnects 1658, and conductive contacts 1660 of the interposer 1657. The conductive contacts 1660 may be coupled to conductive pathways (not shown) through the interposer 1657, allowing circuitry within the dies 1656 to electrically couple to various ones of the conductive contacts 1661 (or to other devices included in the interposer 1657, not shown). The first-level interconnects 1658 illustrated in FIG. 9 are solder bumps, but any suitable first-level interconnects 1658 may be used. As used herein, a "conductive contact" may refer to a portion of conductive material (e.g., metal) serving as an interface between different components; conductive contacts may be recessed in, flush with, or extending away from a surface of a component, and may take any suitable form (e.g., a conductive pad or socket).

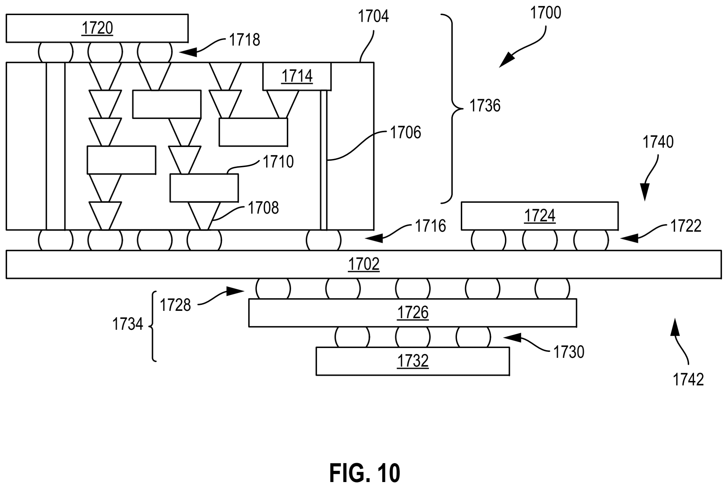

In some embodiments, an underfill material 1666 may be disposed between the package substrate 1652 and the interposer 1657 around the first-level interconnects 1665, and a mold compound 1668 may be disposed around the dies 1656 and the interposer 1657 and in contact with the package substrate 1652. In some embodiments, the underfill material 1666 may be the same as the mold compound 1668. Example materials that may be used for the underfill material 1666 and the mold compound 1668 are epoxy mold materials, as suitable. Second-level interconnects 1670 may be coupled to the conductive contacts 1664. The second-level interconnects 1670 illustrated in FIG. 9 are solder balls (e.g., for a ball grid array arrangement), but any suitable second-level interconnects 1670 may be used (e.g., pins in a pin grid array arrangement or lands in a land grid array arrangement). The second-level interconnects 1670 may be used to couple the IC package 1650 to another component, such as a circuit board (e.g., a motherboard), an interposer, or another IC package, as known in the art and as discussed below with reference to FIG. 10.

The dies 1656 may take the form of any of the embodiments of the die 1502 discussed herein (e.g., may include any of the embodiments of the IC device 1600). In embodiments in which the IC package 1650 includes multiple dies 1656, the IC package 1650 may be referred to as a multichip package (MCP). The dies 1656 may include circuitry to perform any desired functionality. For example, or more of the dies 1656 may be logic dies (e.g., silicon-based dies), and one or more of the dies 1656 may be memory dies (e.g., high-bandwidth memory).

Although the IC package 1650 illustrated in FIG. 9 is a flip chip package, other package architectures may be used. For example, the IC package 1650 may be a ball grid array (BGA) package, such as an embedded wafer-level ball grid array (eWLB) package. In another example, the IC package 1650 may be a wafer-level chip scale package (WLCSP) or a panel fanout (FO) package. Although two dies 1656 are illustrated in the IC package 1650 of FIG. 9, an IC package 1650 may include any desired number of dies 1656. An IC package 1650 may include additional passive components, such as surface-mount resistors, capacitors, and inductors disposed on the first face 1672 or the second face 1674 of the package substrate 1652, or on either face of the interposer 1657. More generally, an IC package 1650 may include any other active or passive components known in the art.

FIG. 10 is a side, cross-sectional view of an IC device assembly 1700 that may include one or more IC packages or other electronic components (e.g., a die) including one or more IC structures 100, 200, 300, 400, 500, and 600 in accordance with any of the embodiments disclosed herein. The IC device assembly 1700 includes a number of components disposed on a circuit board 1702 (which may be, e.g., a motherboard). The IC device assembly 1700 includes components disposed on a first face 1740 of the circuit board 1702 and an opposing second face 1742 of the circuit board 1702; generally, components may be disposed on one or both faces 1740 and 1742. Any of the IC packages discussed below with reference to the IC device assembly 1700 may take the form of any of the embodiments of the IC package 1650 discussed above with reference to FIG. 9 (e.g., may include one or more IC structures 100, 200, 300, 400, 500, and 600).

In some embodiments, the circuit board 1702 may be a PCB including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 1702. In other embodiments, the circuit board 1702 may be a non-PCB substrate.

The IC device assembly 1700 illustrated in FIG. 10 includes a package-on-interposer structure 1736 coupled to the first face 1740 of the circuit board 1702 by coupling components 1716. The coupling components 1716 may electrically and mechanically couple the package-on-interposer structure 1736 to the circuit board 1702, and may include solder balls (as shown in FIG. 10), male and female portions of a socket, an adhesive, an underfill material, and/or any other suitable electrical and/or mechanical coupling structure.

The package-on-interposer structure 1736 may include an IC package 1720 coupled to a package interposer 1704 by coupling components 1718. The coupling components 1718 may take any suitable form for the application, such as the forms discussed above with reference to the coupling components 1716. Although a single IC package 1720 is shown in FIG. 10, multiple IC packages may be coupled to the package interposer 1704; indeed, additional interposers may be coupled to the package interposer 1704. The package interposer 1704 may provide an intervening substrate used to bridge the circuit board 1702 and the IC package 1720. The IC package 1720 may be or include, for example, a die (the die 1502 of FIG. 7), an IC device (e.g., the IC device 1600 of FIG. 8), or any other suitable component. Generally, the package interposer 1704 may spread a connection to a wider pitch or reroute a connection to a different connection. For example, the package interposer 1704 may couple the IC package 1720 (e.g., a die) to a set of BGA conductive contacts of the coupling components 1716 for coupling to the circuit board 1702. In the embodiment illustrated in FIG. 10, the IC package 1720 and the circuit board 1702 are attached to opposing sides of the package interposer 1704; in other embodiments, the IC package 1720 and the circuit board 1702 may be attached to a same side of the package interposer 1704. In some embodiments, three or more components may be interconnected by way of the package interposer 1704.

In some embodiments, the package interposer 1704 may be formed as a PCB, including multiple metal layers separated from one another by layers of dielectric material and interconnected by electrically conductive vias. In some embodiments, the package interposer 1704 may be formed of an epoxy resin, a fiberglass-reinforced epoxy resin, an epoxy resin with inorganic fillers, a ceramic material, or a polymer material such as polyimide. In some embodiments, the package interposer 1704 may be formed of alternate rigid or flexible materials that may include the same materials described above for use in a semiconductor substrate, such as silicon, germanium, and other group III-V and group IV materials. The package interposer 1704 may include metal lines 1710 and vias 1708, including but not limited to through-silicon vias (TSVs) 1706. The package interposer 1704 may further include embedded devices 1714, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as RF devices, power amplifiers, power management devices, antennas, arrays, sensors, and microelectromechanical systems (MEMS) devices may also be formed on the package interposer 1704. The package-on-interposer structure 1736 may take the form of any of the package-on-interposer structures known in the art.

The IC device assembly 1700 may include an IC package 1724 coupled to the first face 1740 of the circuit board 1702 by coupling components 1722. The coupling components 1722 may take the form of any of the embodiments discussed above with reference to the coupling components 1716, and the IC package 1724 may take the form of any of the embodiments discussed above with reference to the IC package 1720.

The IC device assembly 1700 illustrated in FIG. 10 includes a package-on-package structure 1734 coupled to the second face 1742 of the circuit board 1702 by coupling components 1728. The package-on-package structure 1734 may include an IC package 1726 and an IC package 1732 coupled together by coupling components 1730 such that the IC package 1726 is disposed between the circuit board 1702 and the IC package 1732. The coupling components 1728 and 1730 may take the form of any of the embodiments of the coupling components 1716 discussed above, and the IC packages 1726 and 1732 may take the form of any of the embodiments of the IC package 1720 discussed above. The package-on-package structure 1734 may be configured in accordance with any of the package-on-package structures known in the art.

FIG. 11 is a block diagram of an example electrical device 1800 that may include one or more IC structures 100, 200, 300, 400, 500, and 600 in accordance with any of the embodiments disclosed herein. For example, any suitable ones of the components of the electrical device 1800 may include one or more of the IC device assemblies 1700, IC packages 1650, IC devices 1600, or dies 1502 disclosed herein. A number of components are illustrated in FIG. 11 as included in the electrical device 1800, but any one or more of these components may be omitted or duplicated, as suitable for the application. In some embodiments, some or all of the components included in the electrical device 1800 may be attached to one or more motherboards. In some embodiments, some or all of these components are fabricated onto a single system-on-a-chip (SoC) die.

Additionally, in various embodiments, the electrical device 1800 may not include one or more of the components illustrated in FIG. 11, but the electrical device 1800 may include interface circuitry for coupling to the one or more components. For example, the electrical device 1800 may not include a display device 1806, but may include display device interface circuitry (e.g., a connector and driver circuitry) to which a display device 1806 may be coupled. In another set of examples, the electrical device 1800 may not include an audio input device 1824 or an audio output device 1808, but may include audio input or output device interface circuitry (e.g., connectors and supporting circuitry) to which an audio input device 1824 or audio output device 1808 may be coupled.

The electrical device 1800 may include a processing device 1802 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 1802 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices. The electrical device 1800 may include a memory 1804, which may itself include one or more memory devices such as volatile memory (e.g., dynamic RAM (DRAM)), nonvolatile memory (e.g., read-only memory (ROM)), flash memory, solid state memory, and/or a hard drive. In some embodiments, the memory 1804 may include memory that shares a die with the processing device 1802. This memory may be used as cache memory and may include embedded dynamic RAM (eDRAM) or spin transfer torque magnetic RAM (STT-MRAM).

In some embodiments, the electrical device 1800 may include a communication chip 1812 (e.g., one or more communication chips). For example, the communication chip 1812 may be configured for managing wireless communications for the transfer of data to and from the electrical device 1800. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 1812 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 1812 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 1812 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 1812 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 1812 may operate in accordance with other wireless protocols in other embodiments. The electrical device 1800 may include an antenna 1822 to facilitate wireless communications and/or to receive other wireless communications (such as AM or FM radio transmissions).

In some embodiments, the communication chip 1812 may manage wired communications, such as electrical, optical, or any other suitable communication protocols (e.g., the Ethernet). As noted above, the communication chip 1812 may include multiple communication chips. For instance, a first communication chip 1812 may be dedicated to shorter-range wireless communications such as Wi-Fi or Bluetooth, and a second communication chip 1812 may be dedicated to longer-range wireless communications such as global positioning system (GPS), EDGE, GPRS, CDMA, WiMAX, LTE, EV-DO, or others. In some embodiments, a first communication chip 1812 may be dedicated to wireless communications, and a second communication chip 1812 may be dedicated to wired communications.

The electrical device 1800 may include battery/power circuitry 1814. The battery/power circuitry 1814 may include one or more energy storage devices (e.g., batteries or capacitors) and/or circuitry for coupling components of the electrical device 1800 to an energy source separate from the electrical device 1800 (e.g., AC line power).

The electrical device 1800 may include a display device 1806 (or corresponding interface circuitry, as discussed above). The display device 1806 may include any visual indicators, such as a heads-up display, a computer monitor, a projector, a touchscreen display, a liquid crystal display (LCD), a light-emitting diode display, or a flat panel display.

The electrical device 1800 may include an audio output device 1808 (or corresponding interface circuitry, as discussed above). The audio output device 1808 may include any device that generates an audible indicator, such as speakers, headsets, or earbuds.

The electrical device 1800 may include an audio input device 1824 (or corresponding interface circuitry, as discussed above). The audio input device 1824 may include any device that generates a signal representative of a sound, such as microphones, microphone arrays, or digital instruments (e.g., instruments having a musical instrument digital interface (MIDI) output).

The electrical device 1800 may include a GPS device 1818 (or corresponding interface circuitry, as discussed above). The GPS device 1818 may be in communication with a satellite-based system and may receive a location of the electrical device 1800, as known in the art.

The electrical device 1800 may include an other output device 1810 (or corresponding interface circuitry, as discussed above). Examples of the other output device 1810 may include an audio codec, a video codec, a printer, a wired or wireless transmitter for providing information to other devices, or an additional storage device.

The electrical device 1800 may include an other input device 1820 (or corresponding interface circuitry, as discussed above). Examples of the other input device 1820 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The electrical device 1800 may have any desired form factor, such as a handheld or mobile electrical device (e.g., a cell phone, a smart phone, a mobile internet device, a music player, a tablet computer, a laptop computer, a netbook computer, an ultrabook computer, a personal digital assistant (PDA), an ultra mobile personal computer, etc.), a desktop electrical device, a server device or other networked computing component, a printer, a scanner, a monitor, a set-top box, an entertainment control unit, a vehicle control unit, a digital camera, a digital video recorder, or a wearable electrical device. In some embodiments, the electrical device 1800 may be any other electronic device that processes data.

The following paragraphs provide various examples of the embodiments disclosed herein.

Example 1 provides an IC structure, including a device region including a first transistor, where the first transistor includes a first channel region in a first nanoribbon of a semiconductor material, a first source region, and a first drain region, and a second transistor coplanar with and adjacent to the first transistor, where the second transistor includes a second channel region in a second nanoribbon, a second source region, and a second drain region, where the second nanoribbon is coplanar with, adjacent to, and parallel with the first nanoribbon; a metallization stack over the device region, where the metallization stack includes a power rail; a conductive structure (e.g., via contact rail) below, extending parallel with, and in contact with the power rail; a source contact structure between the first source region and the conductive structure (e.g., via contact rail); a drain contact structure coplanar with the source contact structure, where the drain contact structure includes a continuous conductive material between and coupled with the first drain region and the second drain region, where the drain contact structure extends below and substantially orthogonally to the power rail; and an insulator material coplanar with the conductive structure between the drain contact structure and the power rail at an intersection between the drain contact structure and the power rail.

Example 2 provides the IC structure of example 1, where: the power rail is over, parallel with, and substantially aligned with the first nanoribbon; and a portion of the conductive structure is over the first channel region (e.g., the via contact rail may be discontinued part way over the gate).

Example 3 provides the IC structure of example 2, where the insulator material is a first insulator material, and where the IC structure further includes a gate electrode material at least partially around the first channel region; a gate contact structure over and coupled with the gate electrode material; and a second insulator material over the gate electrode material, where the portion of the conductive structure over the first channel region is between second insulator material and the power rail.

Example 4 provides the IC structure of example 3, where the gate electrode material is a first gate electrode material, the continuous conductive material is a first continuous conductive material, and where the IC structure further includes a second gate electrode material at least partially around the second channel region, where: the gate contact structure includes a second continuous conductive material between and coupled with the first gate electrode material and the second gate electrode material, where the gate contact structure extends below and substantially orthogonally to the power rail (e.g., a continuous metal gate line that is not cut in the region under the power rail).

Example 5 provides the IC structure of any one of examples 1-4, where: the first nanoribbon has a first width, the second nanoribbon has a second width, and the first width is greater than the second width.

Example 6 provides the IC structure of example 5, where: the first width is greater than or equal to about two times the second width.

Example 7 provides the IC structure of any one of examples 5-6, further including a third transistor including a third channel region in a third nanoribbon, a third source region, and a third drain region, where: the third nanoribbon is coplanar with, adjacent to, and parallel with the first nanoribbon, and the continuous conductive material of the drain contact structure is further between and coupled with the first drain region and the third drain region.

Example 8 provides the IC structure of example 7, where: the first transistor, the second transistor, and the third transistor are arranged to implement an inverter.

Example 9 provides the IC structure of any one of examples 1-8, where the power rail is a first power rail, the conductive structure is a first conductive structure, and where the IC structure further includes a second power rail parallel to the first power rail; and a second conductive structure (e.g., a second via contact rail) coplanar and parallel to the first conductive structure, where the second conductive structure is below, extending parallel to, and in contact with the second power rail, and where: in a cross-section in plane intersecting the first drain region and the second drain region and substantially orthogonal to the device region, a second portion of the second conductive structure is under the second power rail (e.g., the second via contact rail may be longer and not discontinued).

Example 10 provides the IC structure of any one of examples 1-9, where: the power rail is a conductive interconnect configured to couple with ground or a voltage source.

Example 11 provides the IC structure of any one of examples 1-10, where: the power rail has a first length, the conductive structure (e.g., via contact rail) has a second length, and the second length is smaller than the first length.

Example 12 provides the IC structure of any one of examples 1-11, where: the power rail has a first width, the conductive structure (e.g., via contact rail) has a second width, and the second width is smaller than the first width.

Example 13 provides the IC structure of any one of examples 1-1211, where: the power rail has a first width, the conductive structure (e.g., via contact rail) has a second width, and the second width is about the same as the first width.

Example 14 provides the IC structure of any one of examples 1-13, where: the power rail includes a first conductive material, the conductive structure includes a second conductive material, and the first conductive material has a different material composition than the second conductive material (e.g., the power rail and the via bar may have different compositions).

Example 15 provides the IC structure of any one of examples 1-13, where: the source contact structure includes a first conductive material, the conductive structure includes the first conductive material (e.g., the S/D line and the via bar may have the same material composition), and a liner of a second conductive material is present between the source contact structure and the conductive structure.

Example 16 provides an IC structure, including a device region including a first transistor, where the first transistor includes a first channel region, a first source region, and a first drain region, and a second transistor coplanar with and adjacent to the first transistor, where the second transistor includes a second channel region, a second source region, and a second drain region; a metallization stack over the device region; and a contact structure (e.g., drain contact line) below the metallization stack and including a continuous conductive material between and coupled with the first drain region and the second drain region.

Example 17 provides the IC structure of example 16, where: the first channel region is in a first portion of a first nanoribbon of a semiconductor material, and the second channel region is in a second portion of a second nanoribbon that is coplanar with, adjacent to, and substantially parallel to the first nanoribbon.

Example 18 provides the IC structure of example 16, where the metallization stack is a first metallization stack, and where the IC structure further includes a second metallization stack (e.g., backside metal layers) below the device region, where the second metallization stack includes a power rail coupled with the first source region.

Example 19 provides an IC structure, including a metallization stack; a device region below the metallization stack, where the device region includes transistors arranged to implement an inverter circuit, where the transistors include a first transistor with a first channel region in a first nanoribbon of a semiconductor material, a second transistor with a second channel region in a second nanoribbon coplanar with, adjacent to, and parallel with the first nanoribbon, and a third transistor with a third channel region in a third nanoribbon coplanar with, adjacent to, and parallel with the second nanoribbon; and a conductive contact structure including a continuous conductive material extending substantially orthogonally to the first nanoribbon and coupled with a first drain region of the first transistor, a second drain region of the second transistor, and a third drain region of the third transistor, where the conductive contact structure is below the metallization stack.

Example 20 provides the IC structure of example 19, further including a power rail in a first layer (e.g., M0) of the metallization stack over the device region, where the power rail is coupled with a source region of the second transistor; and a conductive via bar below, in contact with, and extending parallel with a first portion of the power rail, where the conductive via bar is absent from below a second portion of the power rail in a plane substantially orthogonal to the device region and intersecting the first drain region and the second drain region.

Example 21 provides an IC structure according to any one of examples 1-20, where the IC structure includes or is a part of a central processing unit.

Example 22 provides an IC structure according to any one of examples 1-21, where the IC structure includes or is a part of a memory device.

Example 23 provides an IC structure according to any one of examples 1-22, where the IC structure includes or is a part of a logic circuit.

Example 24 provides an IC structure according to any one of examples 1-23, where the IC structure includes or is a part of input/output circuitry.

Example 25 provides an IC structure according to any one of examples 1-24, where the IC structure includes or is a part of a field programmable gate array transceiver.

Example 26 provides an IC structure according to any one of examples 1-25, where the IC structure includes or is a part of a field programmable gate array logic.

Example 27 provides an IC structure according to any one of examples 1-26, where the IC structure includes or is a part of a power delivery circuitry.

Example 28 provides an IC package that includes an IC die including an IC structure according to any one of examples 1-27; and a further IC component, coupled to the IC die.

Example 29 provides an IC package according to example 28 where the further IC component includes a package substrate.

Example 30 provides an IC package according to example 28, where the further IC component includes an interposer.

Example 31 provides an IC package according to example 28, where the further IC component includes a further IC die.

Example 32 provides a computing device that includes a carrier substrate and an IC structure coupled to the carrier substrate, where the IC structure is an IC structure according to any one of examples 1-27, or the IC structure is included in the IC package according to any one of examples 28-31.

Example 33, provides a computing device according to example 32, where the computing device is a wearable or handheld computing device.

Example 34 provides a computing device according to examples 32 or 33, where the computing device further includes one or more communication chips.

Example 35 provides a computing device according to any one of examples 32-34, where the computing device further includes an antenna.

Example 36 provides a computing device according to any one of examples 32-35, where the carrier substrate is a motherboard.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

## Claims

1. An integrated circuit (IC) structure, comprising:
a device region comprising:
a first transistor, wherein the first transistor comprises a first channel region in a first nanoribbon of a semiconductor material, a first source region, and a first drain region, and
a second transistor coplanar with and adjacent to the first transistor, wherein the second transistor comprises a second channel region in a second nanoribbon, a second source region, and a second drain region, wherein the second nanoribbon is coplanar with, adjacent to, and parallel with the first nanoribbon;
a metallization stack over the device region, wherein the metallization stack comprises a power rail;
a conductive structure below, extending parallel with, and in contact with the power rail;
a source contact structure between the first source region and the conductive structure;
a drain contact structure coplanar with the source contact structure, wherein the drain contact structure comprises a continuous conductive material between and coupled with the first drain region and the second drain region, wherein the drain contact structure extends below and substantially orthogonally to the power rail; and
an insulator material coplanar with the conductive structure between the drain contact structure and the power rail at an intersection between the drain contact structure and the power rail.

2. The IC structure of claim 1, wherein:
the power rail is over, parallel with, and substantially aligned with the first nanoribbon; and
a portion of the conductive structure is over the first channel region.

3. The IC structure of claim 2, wherein the insulator material is a first insulator material, and wherein the IC structure further comprises:
a gate electrode material at least partially around the first channel region;
a gate contact structure over and coupled with the gate electrode material; and
a second insulator material over the gate electrode material, wherein the portion of the conductive structure over the first channel region is between the second insulator material and the power rail.

4. The IC structure of claim 3, wherein the gate electrode material is a first gate electrode material, the continuous conductive material is a first continuous conductive material, and wherein the IC structure further comprises:
a second gate electrode material at least partially around the second channel region, wherein:
the gate contact structure comprises a second continuous conductive material between and coupled with the first gate electrode material and the second gate electrode material, wherein the gate contact structure extends below and substantially orthogonally to the power rail.

5. The IC structure of any one of claims 1-4, wherein:
the first nanoribbon has a first width,
the second nanoribbon has a second width, and
the first width is greater than the second width.

6. The IC structure of claim 5, wherein:
the first width is greater than or equal to about two times the second width.

7. The IC structure of claims 5 or 6, further comprising:
a third transistor comprising a third channel region in a third nanoribbon, a third source region, and a third drain region, wherein:
the third nanoribbon is coplanar with, adjacent to, and parallel with the first nanoribbon, and
the continuous conductive material of the drain contact structure is further between and coupled with the first drain region and the third drain region.

8. The IC structure of claim 7, wherein:
the first transistor, the second transistor, and the third transistor are arranged to implement an inverter.

9. The IC structure of any one of claims 1-8, wherein the power rail is a first power rail, the conductive structure is a first conductive structure, and wherein the IC structure further comprises:
a second power rail parallel to the first power rail; and
a second conductive structure coplanar and parallel to the first conductive structure, wherein the second conductive structure is below, extending parallel to, and in contact with the second power rail, and wherein:
in a cross-section in plane intersecting the first drain region and the second drain region and substantially orthogonal to the device region, a second portion of the second conductive structure is under the second power rail.

10. The IC structure of any one of claims 1-9, wherein:
the power rail is a conductive interconnect configured to couple with ground or a voltage source.

11. The IC structure of any one of claims 1-10, wherein:
the power rail has a first length,
the conductive structure has a second length, and
the second length is smaller than the first length.

12. The IC structure of any one of claims 1-11, wherein:
the power rail has a first width,
the conductive structure has a second width, and
the second width is smaller than the first width.

13. The IC structure of any one of claims 1-12, wherein:
the power rail has a first width,
the conductive structure has a second width, and
the second width is about the same as the first width.

14. The IC structure of any one of claims 1-13, wherein:
the power rail comprises a first conductive material,
the conductive structure comprises a second conductive material, and
the first conductive material has a different material composition than the second conductive material.

15. The IC structure of any one of claims 1-13, wherein:
the source contact structure comprises a first conductive material,
the conductive structure comprises the first conductive material, and
a liner of a second conductive material is present between the source contact structure and the conductive structure.
